# EUROPEAN PATENT SPECIFICATION

(11) **EP 2 614 585 B1**
(45) Date of publication and mention of the grant of the patent: **13.03.2019**
(21) Application number: 11758618.0
(22) Date of filing: 07.09.2011
(51) Int. Cl.: H02M 3/07, H02M 3/156, H02M 1/00, H03F 1/52, H03C 3/09, H03G 3/30, H03J 7/04, H04B 1/405, H03F 1/56, H03F 3/189, H03F 3/195, H03F 3/24, H03F 3/68, H03F 3/72, H03F 1/02

(54) **Charge pump buck converter plus buck converter**
Ladungspumpe mit Abwärtswandler, plus Abwärtswandler
Pompe de charge convertisseur Buck, plus convertisseur Buck

(30) Priority: 07.09.2010 US 380522 P; 04.11.2010 US 410071 P; 29.11.2010 US 417633 P; 20.04.2011 US 201113090663; 29.06.2011 US 201113172371; 04.08.2011 US 201113198074
(43) Date of publication of application: 17.07.2013
(73) Proprietor: Qorvo US, Inc., Greensboro, NC 27409 (US)
(72) Inventor: LEVESQUE, Chris, Fountain Valley CA 92708 (US); BERCHTOLD, Jean-Christophe, Carlsbad CA 92008 (US); COLLES, Joseph, Hubert, Bonsall CA 92003 (US); DEUCHARS, Robert, Carlsbad CA 92010 (US); SOUTHCOMBE, William, David, San Diego CA 92130 (US); ZIMLICH, David, San Diego CA 92127 (US); JONES, David, E., Cedar Rapids IA 52411 (US); YODER, Scott, Holly Springs NC 27540 (US); STOCKERT, Terry, J., Cedar Rapids IA 52405 (US)
(74) Representative: FRKelly
(86) International application number: PCT/US2011/050633
(87) International publication number: WO 2012/033801

(56) References cited:
- GB-A- 2 444 984
- US-A1- 2003 227 280
- US-A1- 2007 024 360
- US-A1- 2008 023 825
- US-A1- 2008 081 572
- US-A1- 2010 013 548

## Description

### Field of the Disclosure

Embodiments of the present disclosure relate to radio frequency (RF) power amplifier (PA) circuitry, which may be used in RF communications systems.

### Background of the Disclosure

Portable wireless communications devices are typically battery powered, need to be relatively small, and have low cost. As such, to minimize size, cost, and power consumption, multi-mode multi-band RF circuitry in such a device needs to be as simple, small, and efficient as is practical. The patent document US-A1-2010/013 548 describes a charge pump which uses a current limit resistor to limit in-rush current and peak currents. When coupled to a boost converter or other switching converter utilizing an inductive energy storage element, the charge pump may avoid necessary power dissipation caused by the current limit resistor. Thus, there is a need for multi-mode multi-band RF circuitry in a multi-mode multi-band communications device that is low cost, small, simple, efficient, and meets performance requirements.

### Summary of the Embodiments

The present disclosure provides circuitry as detailed in claim 1. Advantageous features are provided in dependent claims.

First Embodiment: Voltage Compatible Charge Pump Buck and Buck Power Supplies

The present disclosure relates to a flexible DC-DC converter, which includes a charge pump buck power supply and a buck power supply. The charge pump buck power supply and the buck power supply are voltage compatible with one another at respective output inductance nodes to provide flexibility. In one embodiment of the DC-DC converter, capacitances at the output inductance nodes are at least partially isolated from one another by using at least an isolating inductive element between the output inductance nodes to increase efficiency. In an alternate embodiment of the DC-DC converter, the output inductance nodes are coupled to one another, such that the charge pump buck power supply and the buck power supply share a first inductive element, thereby eliminating the isolating inductive element, which reduces size and cost but may also reduce efficiency. In both embodiments, the charge pump buck power supply and the buck power supply share an energy storage element. Specifically, the charge pump buck power supply includes a charge pump buck converter having a first output inductance node, a first inductive element, and the energy storage element, such that the first inductive element is coupled between the first output inductance node and the energy storage element. The buck power supply includes a buck converter having a second output inductance node, and the energy storage element. The buck power supply at the second output inductance node is voltage compatible with the charge pump buck power supply at the first output inductance node to provide flexibility.

Second Embodiment: Charge Pump Based PA Envelope Power Supply and Bias Power Supply

The present disclosure relates to a DC-DC converter, which includes a charge pump based RF PA envelope power supply and a charge pump based PA bias power supply. The DC-DC converter is coupled between RF PA circuitry and a DC power supply, such as a battery. As such, the PA envelope power supply provides an envelope power supply signal to the RF PA circuitry and the PA bias power supply provides a bias power supply signal to the RF PA circuitry. Both the PA envelope power supply and the PA bias power supply receive power via a DC power supply signal from the DC power supply. The PA envelope power supply includes a charge pump buck converter and the PA bias power supply includes a charge pump.

Those skilled in the art will appreciate the scope of the present disclosure and realize additional aspects thereof after reading the following detailed description of the preferred embodiments in association with the accompanying drawing figures.

### Brief Description of the Drawing Figures

The accompanying drawing figures incorporated in and forming a part of this specification illustrate several aspects of the disclosure, and together with the description serve to explain the principles of the disclosure.
Figure 1 shows an RF communications system according to one embodiment of the RF communications system.
Figure 2 shows the RF communications system according to an alternate embodiment of the RF communications system.
Figure 3 shows the RF communications system according to an additional embodiment of the RF communications system.
Figure 4 shows the RF communications system according to another embodiment of the RF communications system.
Figure 5 shows the RF communications system according to a further embodiment of the RF communications system.
Figure 6 shows the RF communications system according to one embodiment of the RF communications system.
Figure 7 shows the RF communications system according to one embodiment of the RF communications system.
Figure 8 shows the RF communications system according to an alternate embodiment of the RF communications system.
Figure 9 shows details of a direct current (DC)-DC converter illustrated in Figure 8 according to an alternate embodiment of the DC-DC converter.
Figure 10 shows the RF communications system according to one embodiment of the RF communications system.
Figure 11 shows details of a PA envelope power supply and a PA bias power supply illustrated in Figure 10 according to one embodiment of the PA envelope power supply and the PA bias power supply.
Figure 12 shows details of the PA envelope power supply and the PA bias power supply illustrated in Figure 10 according to an alternate embodiment of the PA envelope power supply and the PA bias power supply.
Figure 13 shows details of the PA envelope power supply and the PA bias power supply illustrated in Figure 10 according to an additional embodiment of the PA envelope power supply and the PA bias power supply.
Figure 14 shows the DC-DC converter according to one embodiment of the DC-DC converter.
Figure 15 shows details of a first switching power supply illustrated in Figure 14 according to one embodiment of the first switching power supply.
Figure 16 shows details of the first switching power supply and a second switching power supply illustrated in Figure 15 according to an alternate embodiment of the first switching power supply and one embodiment of the second switching power supply.
Figure 17 shows details of the first switching power supply and the second switching power supply illustrated in Figure 15 according to an additional embodiment of the first switching power supply and one embodiment of the second switching power supply.
Figure 18 shows details of the first switching power supply illustrated in Figure 16 according to one embodiment of the first switching power supply.
Figure 19 shows details of the first switching power supply illustrated in Figure 16 according to a further embodiment of the first switching power supply.
Figure 20 shows details of the first switching power supply illustrated in Figure 17 according to an alternate embodiment of the first switching power supply.
Figure 21 shows details of the first switching power supply illustrated in Figure 16 according to an additional embodiment of the first switching power supply.
Figure 22 shows details of the first switching power supply illustrated in Figure 17 according to another embodiment of the first switching power supply.
Figure 23 shows details of charge pump buck switching circuitry and the buck switching circuitry illustrated in Figure 18 according to one embodiment of the charge pump buck switching circuitry and the buck switching circuitry.
Figure 24 shows details of charge pump buck switching circuitry and the buck switching circuitry illustrated in Figure 18 according to an alternate embodiment of the buck switching circuitry.
Figure 25 shows details of a charge pump buck switch circuit illustrated in Figure 23 according to one embodiment of the charge pump buck switch circuit.
Figure 26A and Figure 26B are graphs of a pulse width modulation (PWM) signal of the first switching power supply illustrated in Figure 18 according to one embodiment of the first switching power supply.
Figure 27 shows details of the charge pump buck switching circuitry and the buck switching circuitry illustrated in Figure 20 according to an additional embodiment of the buck switching circuitry.

### Detailed Description of the Preferred Embodiments

The embodiments set forth below represent the necessary information to enable those skilled in the art to practice the disclosure and illustrate the best mode of practicing the disclosure. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

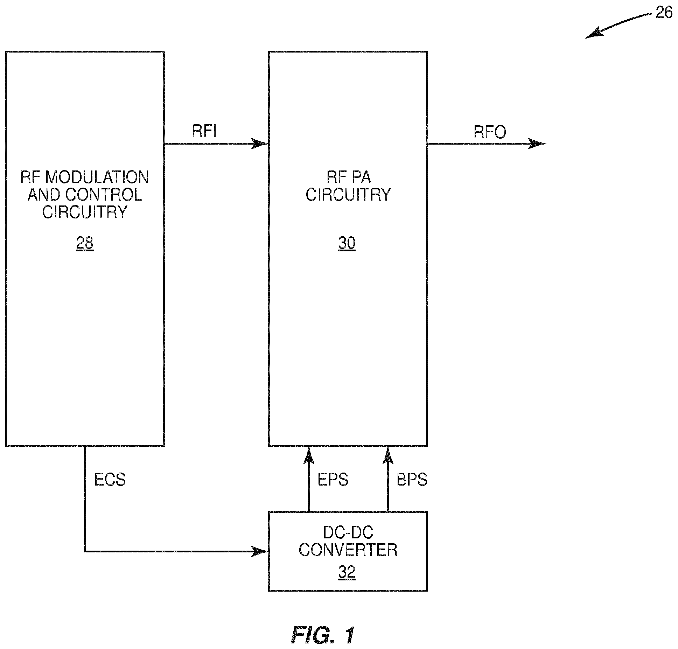

Figure 1 shows an RF communications system 26 according to one embodiment of the RF communications system 26. The RF communications system 26 includes RF modulation and control circuitry 28, RF PA circuitry 30, and a DC-DC converter 32. The RF modulation and control circuitry 28 provides an envelope control signal ECS to the DC-DC converter 32 and provides an RF input signal RFI to the RF PA circuitry 30. The DC-DC converter 32 provides a bias power supply signal BPS and an envelope power supply signal EPS to the RF PA circuitry 30. The envelope power supply signal EPS may be based on the envelope control signal ECS. As such, a magnitude of the envelope power supply signal EPS may be controlled by the RF modulation and control circuitry 28 via the envelope control signal ECS. The RF PA circuitry 30 may receive and amplify the RF input signal RFI to provide an RF output signal RFO. The envelope power supply signal EPS may provide power for amplification of the RF input signal RFI to the RF PA circuitry 30. The RF PA circuitry 30 may use the bias power supply signal BPS to provide biasing of amplifying elements in the RF PA circuitry 30.

In a first embodiment of the RF communications system 26, the RF communications system 26 is a multi-mode RF communications system 26. As such, the RF communications system 26 may operate using multiple communications modes. In this regard, the RF modulation and control circuitry 28 may be multi-mode RF modulation and control circuitry 28 and the RF PA circuitry 30 may be multi-mode RF PA circuitry 30. In a second embodiment of the RF communications system 26, the RF communications system 26 is a multi-band RF communications system 26. As such, the RF communications system 26 may operate using multiple RF communications bands. In this regard, the RF modulation and control circuitry 28 may be multi-band RF modulation and control circuitry 28 and the RF PA circuitry 30 may be multi-band RF PA circuitry 30. In a third embodiment of the RF communications system 26, the RF communications system 26 is a multi-mode multi-band RF communications system 26. As such, the RF communications system 26 may operate using multiple communications modes, multiple RF communications bands, or both. In this regard, the RF modulation and control circuitry 28 may be multi-mode multi-band RF modulation and control circuitry 28 and the RF PA circuitry 30 may be multi-mode multi-band RF PA circuitry 30.

The communications modes may be associated with any number of different communications protocols, such as Global System of Mobile communications (GSM), Gaussian Minimum Shift Keying (GMSK), IS-136, Enhanced Data rates for GSM Evolution (EDGE), Code Division Multiple Access (CDMA), Universal Mobile Telecommunications System (UMTS) protocols, such as Wideband CDMA (WCDMA), Worldwide Interoperability for Microwave Access (WIMAX), Long Term Evolution (LTE), or the like. The GSM, GMSK, and IS-136 protocols typically do not include amplitude modulation (AM). As such, the GSM, GMSK, and IS-136 protocols may be associated with a non-linear mode. Further, the GSM, GMSK, and IS-136 protocols may be associated with a saturated mode. The EDGE, CDMA, UMTS, WCDMA, WIMAX, and LTE protocols may include AM. As such, the EDGE, CDMA, UMTS, WCDMA, WIMAX, and LTE protocols may be associated with a linear mode.

In one embodiment of the RF communications system 26, the RF communications system 26 is a mobile communications terminal, such as a cell phone, smartphone, laptop computer, tablet computer, personal digital assistant (PDA), or the like. In an alternate embodiment of the RF communications system 26, the RF communications system 26 is a fixed communications terminal, such as a base station, a cellular base station, a wireless router, a hotspot distribution node, a wireless access point, or the like. The antenna 18 may include any apparatus for conveying RF transmit and RF receive signals to and from at least one other RF communications system. As such, in one embodiment of the antenna 18, the antenna 18 is a single antenna. In an alternate embodiment of the antenna 18, the antenna 18 is an antenna array having multiple radiating and receiving elements. In an additional embodiment of the antenna 18, the antenna 18 is a distribution system for transmitting and receiving RF signals.

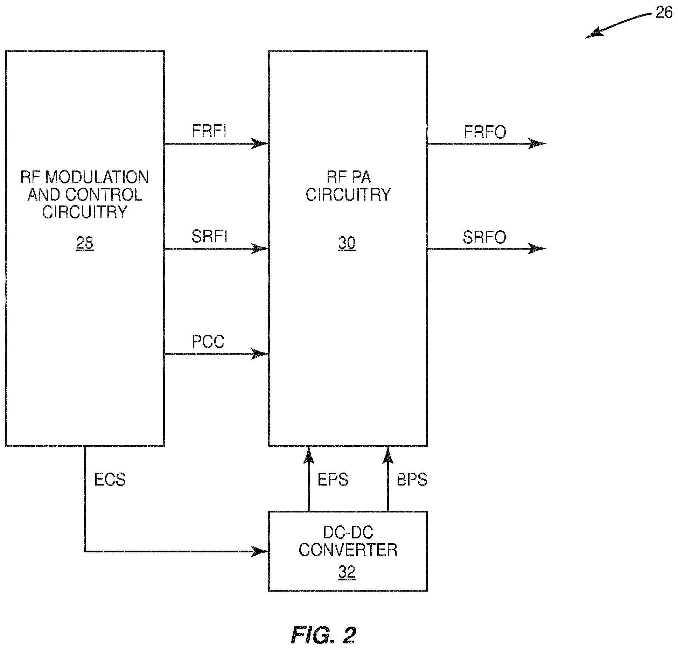

Figure 2 shows the RF communications system 26 according to an alternate embodiment of the RF communications system 26. The RF communications system 26 illustrated in Figure 2 is similar to the RF communications system 26 illustrated in Figure 1, except in the RF communications system 26 illustrated in Figure 2, the RF modulation and control circuitry 28 provides a first RF input signal FRFI, a second RF input signal SRFI, and a PA configuration control signal PCC to the RF PA circuitry 30. The RF PA circuitry 30 may receive and amplify the first RF input signal FRFI to provide a first RF output signal FRFO. The envelope power supply signal EPS may provide power for amplification of the first RF input signal FRFI to the RF PA circuitry 30. The RF PA circuitry 30 may receive and amplify the second RF input signal SRFI to provide a second RF output signal SRFO. The envelope power supply signal EPS may provide power for amplification of the second RF output signal SRFO to the RF PA circuitry 30. Certain configurations of the RF PA circuitry 30 may be based on the PA configuration control signal PCC. As a result, the RF modulation and control circuitry 28 may control such configurations of the RF PA circuitry 30.

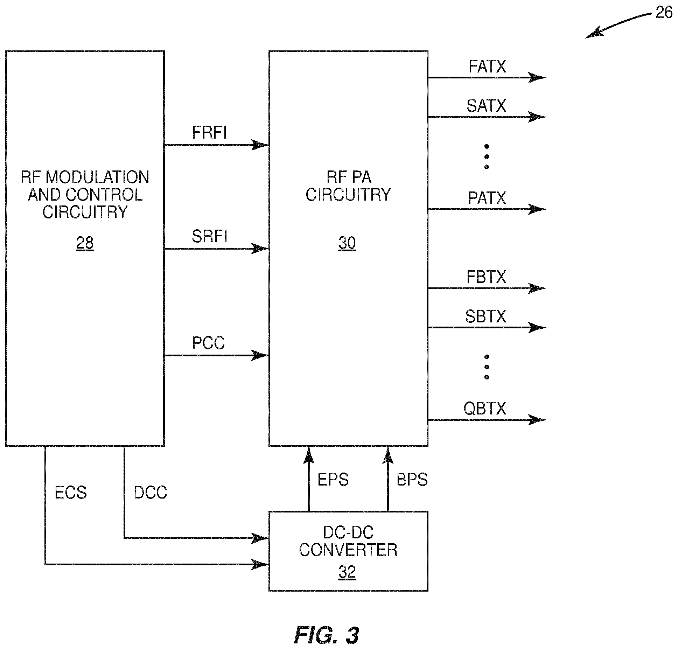

Figure 3 shows the RF communications system 26 according to an additional embodiment of the RF communications system 26. The RF communications system 26 illustrated in Figure 3 is similar to the RF communications system 26 illustrated in Figure 2, except in the RF communications system 26 illustrated in Figure 3, the RF PA circuitry 30 does not provide the first RF output signal FRFO and the second RF output signal SRFO. Instead, the RF PA circuitry 30 may provide one of a first alpha RF transmit signal FATX, a second alpha RF transmit signal SATX, and up to and including a P^{TH} alpha RF transmit signal PATX based on receiving and amplifying the first RF input signal FRFI. Similarly, the RF PA circuitry 30 may provide one of a first beta RF transmit signal FBTX, a second beta RF transmit signal SBTX, and up to and including a Q^{TH} beta RF transmit signal QBTX based on receiving and amplifying the second RF input signal SRFI. The one of the transmit signals FATX, SATX, PATX, FBTX, SBTX, QBTX that is selected may be based on the PA configuration control signal PCC. Additionally, the RF modulation and control circuitry 28 may provide a DC configuration control signal DCC to the DC-DC converter 32. Certain configurations of the DC-DC converter 32 may be based on the DC configuration control signal DCC.

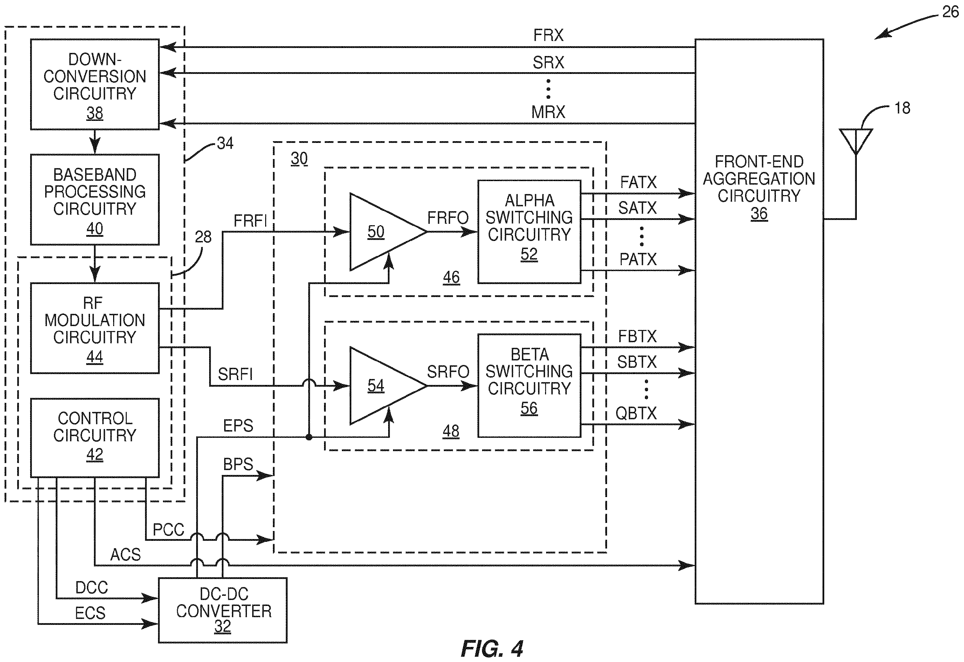

Figure 4 shows the RF communications system 26 according to another embodiment of the RF communications system 26. The RF communications system 26 illustrated in Figure 4 shows details of the RF modulation and control circuitry 28 and the RF PA circuitry 30 illustrated in Figure 3. Additionally, the RF communications system 26 illustrated in Figure 4 further includes transceiver circuitry 34, front-end aggregation circuitry 36, and an antenna 18. The transceiver circuitry 34 includes down-conversion circuitry 38, baseband processing circuitry 40, and the RF modulation and control circuitry 28, which includes control circuitry 42 and RF modulation circuitry 44. The RF PA circuitry 30 includes a first transmit path 46 and a second transmit path 48. The first transmit path 46 includes a first RF PA 50 and alpha switching circuitry 52. The second transmit path 48 includes a second RF PA 54 and beta switching circuitry 56. The front-end aggregation circuitry 36 is coupled to the antenna 18. The control circuitry 42 provides the aggregation control signal ACS to the front-end aggregation circuitry 36. Configuration of the front-end aggregation circuitry 36 may be based on the aggregation control signal ACS. As such, configuration of the front-end aggregation circuitry 36 may be controlled by the control circuitry 42 via the aggregation control signal ACS.

The control circuitry 42 provides the envelope control signal ECS and the DC configuration control signal DCC to the DC-DC converter 32. Further, the control circuitry 42 provides the PA configuration control signal PCC to the RF PA circuitry 30. As such, the control circuitry 42 may control configuration of the RF PA circuitry 30 via the PA configuration control signal PCC and may control a magnitude of the envelope power supply signal EPS via the envelope control signal ECS. The control circuitry 42 may select one of multiple communications modes, which may include a first half-duplex transmit mode, a first half-duplex receive mode, a second half-duplex transmit mode, a second half-duplex receive mode, a first full-duplex mode, a second full-duplex mode, at least one linear mode, at least one non-linear mode, multiple RF modulation modes, or any combination thereof. Further, the control circuitry 42 may select one of multiple frequency bands. The control circuitry 42 may provide the aggregation control signal ACS to the front-end aggregation circuitry 36 based on the selected mode and the selected frequency band. The front-end aggregation circuitry 36 may include various RF components, including RF switches; RF filters, such as bandpass filters, harmonic filters, and duplexers; RF amplifiers, such as low noise amplifiers (LNAs); impedance matching circuitry; the like; or any combination thereof. In this regard, routing of RF receive signals and RF transmit signals through the RF components may be based on the selected mode and the selected frequency band as directed by the aggregation control signal ACS.

The down-conversion circuitry 38 may receive the first RF receive signal FRX, the second RF receive signal SRX, and up to and including the M^{TH} RF receive signal MRX from the antenna 18 via the front-end aggregation circuitry 36. Each of the RF receive signals FRX, SRX, MRX may be associated with at least one selected mode, at least one selected frequency band, or both. The down-conversion circuitry 38 may down-convert any of the RF receive signals FRX, SRX, MRX to baseband receive signals, which may be forwarded to the baseband processing circuitry 40 for processing. The baseband processing circuitry 40 may provide baseband transmit signals to the RF modulation circuitry 44, which may RF modulate the baseband transmit signals to provide the first RF input signal FRFI or the second RF input signal SRFI to the first RF PA 50 or the second RF PA 54, respectively, depending on the selected communications mode.

The first RF PA 50 may receive and amplify the first RF input signal FRFI to provide the first RF output signal FRFO to the alpha switching circuitry 52. Similarly, the second RF PA 54 may receive and amplify the second RF input signal SRFI to provide the second RF output signal SRFO to the beta switching circuitry 56. The first RF PA 50 and the second RF PA 54 may receive the envelope power supply signal EPS, which may provide power for amplification of the first RF input signal FRFI and the second RF input signal SRFI, respectively. The first RF PA 50 and the second RF PA 54 may receive the bias power supply signal BPS, which may be used to bias the first RF PA 50 and the second RF PA 54, respectively. The alpha switching circuitry 52 may forward the first RF output signal FRFO to provide one of the alpha transmit signals FATX, SATX, PATX to the antenna 18 via the front-end aggregation circuitry 36, depending on the selected communications mode based on the PA configuration control signal PCC. Similarly, the beta switching circuitry 56 may forward the second RF output signal SRFO to provide one of the beta transmit signals FBTX, SBTX, QBTX to the antenna 18 via the front-end aggregation circuitry 36, depending on the selected communications mode based on the PA configuration control signal PCC.

In one embodiment of the RF PA circuitry 30, the RF PA circuitry 30 operates in one of a first PA operating mode and a second PA operating mode. During the first PA operating mode, the first RF PA 50 receives and amplifies the first RF input signal FRFI to provide the first RF output signal FRFO, and the second RF PA 54 is disabled. During the second PA operating mode, the second RF PA 54 receives and amplifies the second RF input signal SRFI to provide the second RF output signal SRFO, and the first RF PA 50 is disabled. In one embodiment of the RF communications system 26, the first RF input signal FRFI is a highband RF input signal and the second RF input signal SRFI is a lowband RF input signal. In one exemplary embodiment of the RF communications system 26, a difference between a frequency of the highband RF input signal and a frequency of the lowband RF input signal is greater than about 500 megahertz, such that the frequency of the highband RF input signal is greater than the frequency of the lowband RF input signal. In an additional exemplary embodiment of the RF communications system 26, a ratio of a frequency of the highband RF input signal divided by a frequency of the lowband RF input signal is greater than about 1.5.

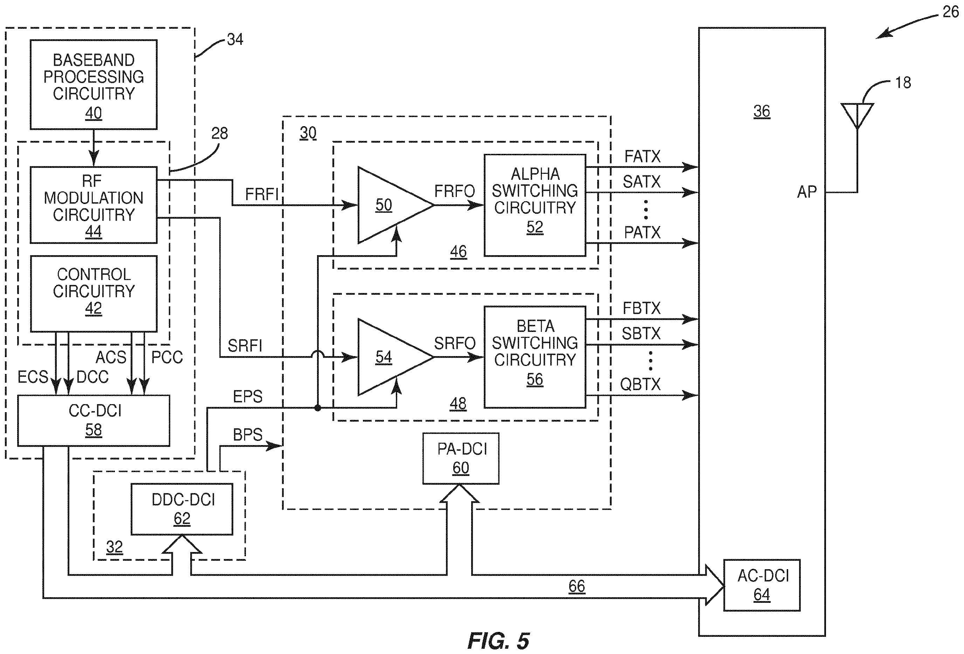

Figure 5 shows the RF communications system 26 according to a further embodiment of the RF communications system 26. The RF communications system 26 illustrated in Figure 5 is similar to the RF communications system 26 illustrated in Figure 4, except in the RF communications system 26 illustrated in Figure 5, the transceiver circuitry 34 includes a control circuitry digital communications interface (DCI) 58, the RF PA circuitry 30 includes a PA-DCI 60, the DC-DC converter 32 includes a DC-DC converter DCI 62, and the front-end aggregation circuitry 36 includes an aggregation circuitry DCI 64. The front-end aggregation circuitry 36 includes an antenna port AP, which is coupled to the antenna 18. In one embodiment of the RF communications system 26, the antenna port AP is directly coupled to the antenna 18. In one embodiment of the RF communications system 26, the front-end aggregation circuitry 36 is coupled between the alpha switching circuitry 52 and the antenna port AP. Further, the front-end aggregation circuitry 36 is coupled between the beta switching circuitry 56 and the antenna port AP. The alpha switching circuitry 52 may be multi-mode multi-band alpha switching circuitry and the beta switching circuitry 56 may be multi-mode multi-band beta switching circuitry.

The DCIs 58, 60, 62, 64 are coupled to one another using a digital communications bus 66. In the digital communications bus 66 illustrated in Figure 5, the digital communications bus 66 is a uni-directional bus in which the control circuitry DCI 58 may communicate information to the PA-DCI 60, the DC-DC converter DCI 62, the aggregation circuitry DCI 64, or any combination thereof. As such, the control circuitry 42 may provide the envelope control signal ECS and the DC configuration control signal DCC via the control circuitry DCI 58 to the DC-DC converter 32 via the DC-DC converter DCI 62. Similarly, the control circuitry 42 may provide the aggregation control signal ACS via the control circuitry DCI 58 to the front-end aggregation circuitry 36 via the aggregation circuitry DCI 64. Additionally, the control circuitry 42 may provide the PA configuration control signal PCC via the control circuitry DCI 58 to the RF PA circuitry 30 via the PA-DCI 60.

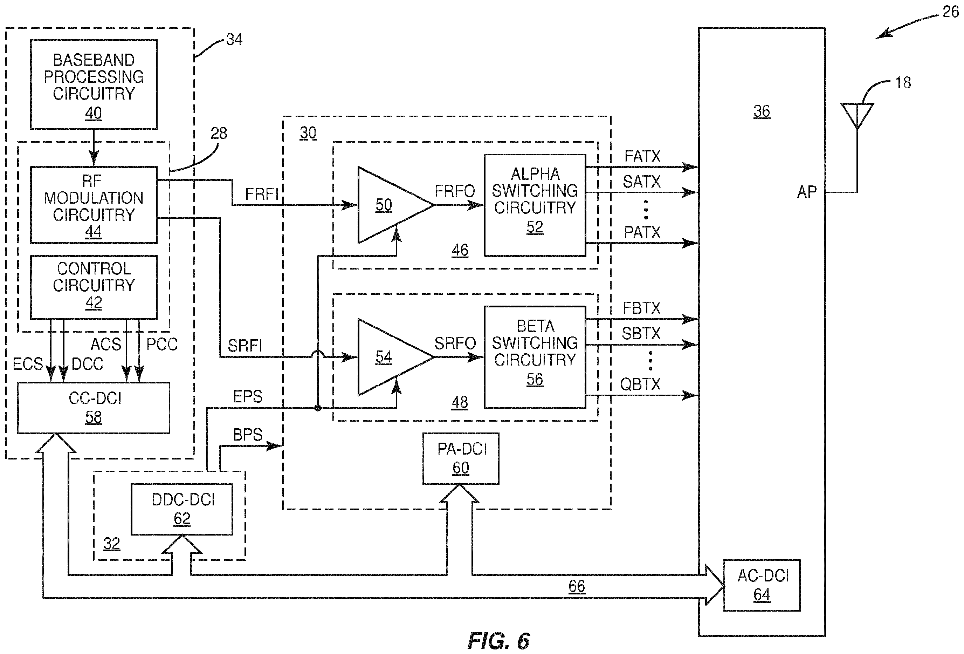

Figure 6 shows the RF communications system 26 according to one embodiment of the RF communications system 26. The RF communications system 26 illustrated in Figure 6 is similar to the RF communications system 26 illustrated in Figure 5, except in the RF communications system 26 illustrated in Figure 6, the digital communications bus 66 is a bi-directional bus and each of the DCIs 58, 60, 62, 64 is capable of receiving or transmitting information. In alternate embodiments of the RF communications system 26, any or all of the DCIs 58, 60, 62, 64 may be uni-directional and any or all of the DCIs 58, 60, 62, 64 may be bi-directional.

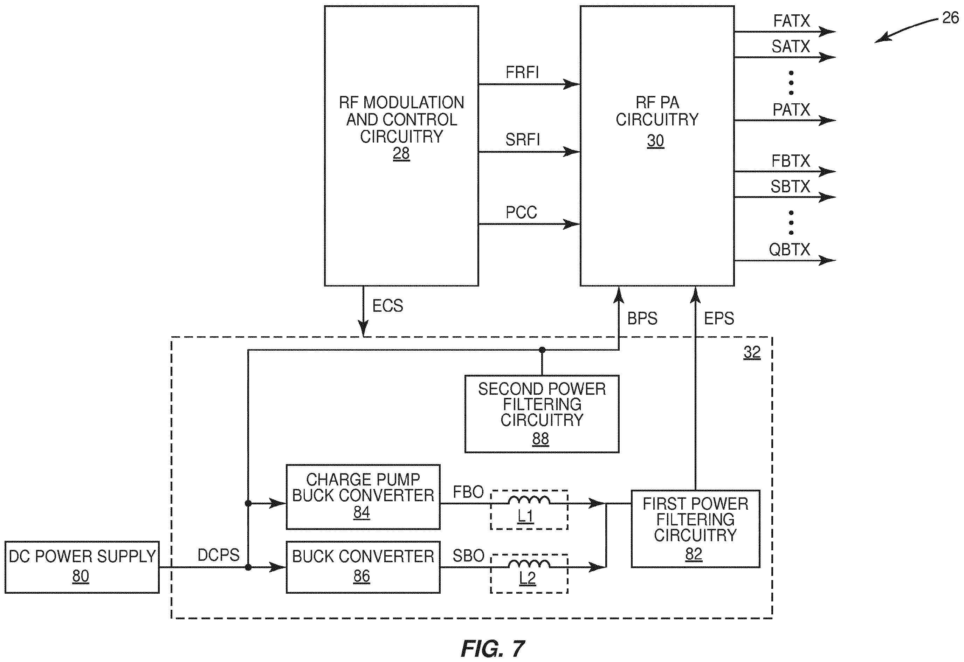

Figure 7 shows the RF communications system 26 according to one embodiment of the RF communications system 26. The RF communications system 26 shown in Figure 7 is similar to the RF communications system 26 shown in Figure 3, except the RF communications system 26 illustrated in Figure 7 further includes a DC power supply 80 and the DC configuration control signal DCC is omitted. Additionally, details of the DC-DC converter 32 are shown according to one embodiment of the DC-DC converter 32. The DC-DC converter 32 includes first power filtering circuitry 82, a charge pump buck converter 84, a buck converter 86, second power filtering circuitry 88, a first inductive element L1, and a second inductive element L2. The DC power supply 80 provides a DC power supply signal DCPS to the charge pump buck converter 84, the buck converter 86, and the second power filtering circuitry 88. In one embodiment of the DC power supply 80, the DC power supply 80 is a battery.

The second power filtering circuitry 88 is coupled to the RF PA circuitry 30 and to the DC power supply 80. The charge pump buck converter 84 is coupled to the DC power supply 80. The first inductive element L1 is coupled between the charge pump buck converter 84 and the first power filtering circuitry 82. The buck converter 86 is coupled to the DC power supply 80. The second inductive element L2 is coupled between the buck converter 86 and the first power filtering circuitry 82. The first power filtering circuitry 82 is coupled to the RF PA circuitry 30. One end of the first inductive element L1 is coupled to one end of the second inductive element L2 at the first power filtering circuitry 82.

In one embodiment of the DC-DC converter 32, the DC-DC converter 32 operates in one of multiple converter operating modes, which include a first converter operating mode, a second converter operating mode, and a third converter operating mode. In an alternate embodiment of the DC-DC converter 32, the DC-DC converter 32 operates in one of the first converter operating mode and the second converter operating mode. In the first converter operating mode, the charge pump buck converter 84 is active, such that the envelope power supply signal EPS is based on the DC power supply signal DCPS via the charge pump buck converter 84, and the first inductive element L1. In the first converter operating mode, the buck converter 86 is inactive and does not contribute to the envelope power supply signal EPS. In the second converter operating mode, the buck converter 86 is active, such that the envelope power supply signal EPS is based on the DC power supply signal DCPS via the buck converter 86 and the second inductive element L2. In the second converter operating mode, the charge pump buck converter 84 is inactive, such that the charge pump buck converter 84 does not contribute to the envelope power supply signal EPS. In the third converter operating mode, the charge pump buck converter 84 and the buck converter 86 are active, such that either the charge pump buck converter 84; the buck converter 86; or both may contribute to the envelope power supply signal EPS. As such, in the third converter operating mode, the envelope power supply signal EPS is based on the DC power supply signal DCPS either via the charge pump buck converter 84, and the first inductive element L1; via the buck converter 86 and the second inductive element L2; or both.

The second power filtering circuitry 88 filters the DC power supply signal DCPS to provide the bias power supply signal BPS. The second power filtering circuitry 88 may function as a lowpass filter by removing ripple, noise, and the like from the DC power supply signal DCPS to provide the bias power supply signal BPS. As such, in one embodiment of the DC-DC converter 32, the bias power supply signal BPS is based on the DC power supply signal DCPS.

In the first converter operating mode or the third converter operating mode, the charge pump buck converter 84 may receive, charge pump, and buck convert the DC power supply signal DCPS to provide a first buck output signal FBO to the first inductive element L1. As such, in one embodiment of the charge pump buck converter 84, the first buck output signal FBO is based on the DC power supply signal DCPS. Further, the first inductive element L1 may function as a first energy transfer element of the charge pump buck converter 84 to transfer energy via the first buck output signal FBO to the first power filtering circuitry 82. In the first converter operating mode or the third converter operating mode, the first inductive element L1 and the first power filtering circuitry 82 may receive and filter the first buck output signal FBO to provide the envelope power supply signal EPS. The charge pump buck converter 84 may regulate the envelope power supply signal EPS by controlling the first buck output signal FBO based on a setpoint of the envelope power supply signal EPS provided by the envelope control signal ECS.

In the second converter operating mode or the third converter operating mode, the buck converter 86 may receive and buck convert the DC power supply signal DCPS to provide a second buck output signal SBO to the second inductive element L2. As such, in one embodiment of the buck converter 86, the second buck output signal SBO is based on the DC power supply signal DCPS. Further, the second inductive element L2 may function as a second energy transfer element of the buck converter 86 to transfer energy via the first power filtering circuitry 82 to the first power filtering circuitry 82. In the second converter operating mode or the third converter operating mode, the second inductive element L2 and the first power filtering circuitry 82 may receive and filter the second buck output signal SBO to provide the envelope power supply signal EPS. The buck converter 86 may regulate the envelope power supply signal EPS by controlling the second buck output signal SBO based on a setpoint of the envelope power supply signal EPS provided by the envelope control signal ECS.

In one embodiment of the charge pump buck converter 84, the charge pump buck converter 84 operates in one of multiple pump buck operating modes. During a pump buck pump-up operating mode of the charge pump buck converter 84, the charge pump buck converter 84 pumps-up the DC power supply signal DCPS to provide an internal signal (not shown), such that a voltage of the internal signal is greater than a voltage of the DC power supply signal DCPS. In an alternate embodiment of the charge pump buck converter 84, during the pump buck pump-up operating mode, a voltage of the envelope power supply signal EPS is greater than the voltage of the DC power supply signal DCPS. During a pump buck pump-down operating mode of the charge pump buck converter 84, the charge pump buck converter 84 pumps-down the DC power supply signal DCPS to provide the internal signal, such that a voltage of the internal signal is less than a voltage of the DC power supply signal DCPS. In an alternate embodiment of the charge pump buck converter 84, during the pump buck pump-down operating mode, the voltage of the envelope power supply signal EPS is less than the voltage of the DC power supply signal DCPS. During a pump buck pump-even operating mode of the charge pump buck converter 84, the charge pump buck converter 84 pumps the DC power supply signal DCPS to the internal signal, such that a voltage of the internal signal is about equal to a voltage of the DC power supply signal DCPS. One embodiment of the DC-DC converter 32 includes a pump buck bypass operating mode of the charge pump buck converter 84, such that during the pump buck bypass operating mode, the charge pump buck converter 84 by-passes charge pump circuitry (not shown) using by-pass circuitry (not shown) to forward the DC power supply signal DCPS to provide the internal signal, such that a voltage of the internal is about equal to a voltage of the DC power supply signal DCPS.

In one embodiment of the charge pump buck converter 84, the pump buck operating modes include the pump buck pump-up operating mode, the pump buck pump-down operating mode, the pump buck pump-even operating mode, and the pump buck bypass operating mode. In an alternate embodiment of the charge pump buck converter 84, the pump buck pump-even operating mode is omitted. In an additional embodiment of the charge pump buck converter 84, the pump buck bypass operating mode is omitted. In another embodiment of the charge pump buck converter 84, the pump buck pump-down operating mode is omitted. In a further embodiment of the charge pump buck converter 84, any or all of the pump buck pump-up operating mode, the pump buck pump-down operating mode, the pump buck pump-even operating mode, and the pump buck bypass operating mode are omitted. In a supplemental embodiment of the charge pump buck converter 84, the charge pump buck converter 84 operates in only the pump buck pump-up operating mode. In an additional embodiment of the charge pump buck converter 84, the charge pump buck converter 84 operates in one of the pump buck pump-up operating mode and at least one other pump buck operating mode of the charge pump buck converter 84. The at least one other pump buck operating mode of the charge pump buck converter 84 may include any or all of the pump buck pump-up operating mode, the pump buck pump-down operating mode, the pump buck pump-even operating mode, and the pump buck bypass operating mode.

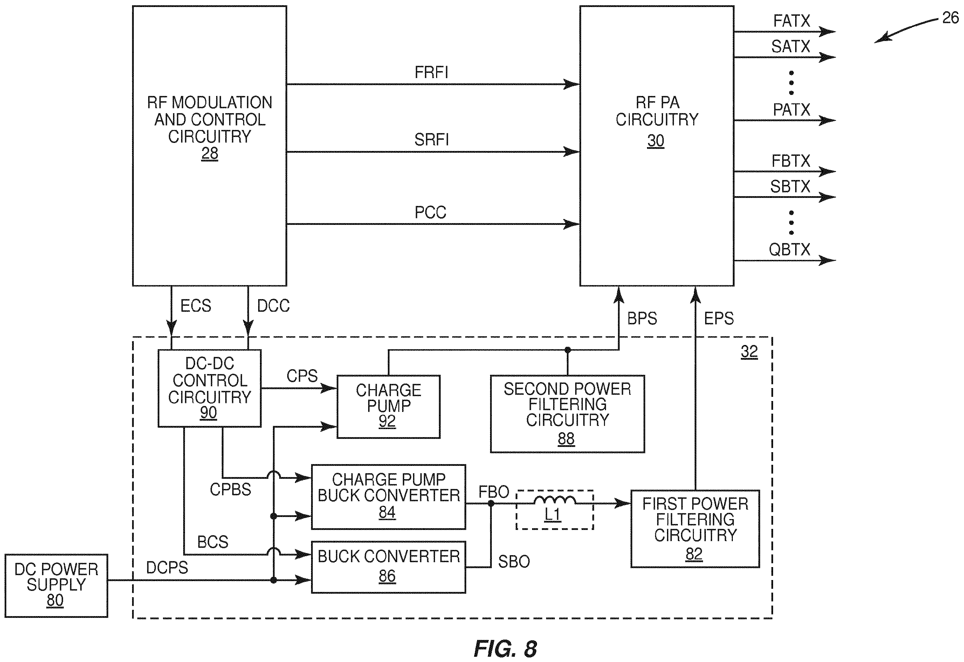

Figure 8 shows the RF communications system 26 according to an alternate embodiment of the RF communications system 26. The RF communications system 26 illustrated in Figure 8 is similar to the RF communications system 26 illustrated in Figure 7, except in the RF communications system 26 illustrated in Figure 8, the DC-DC converter 32 further includes DC-DC control circuitry 90 and a charge pump 92, and omits the second inductive element L2. Instead of the second power filtering circuitry 88 being coupled to the DC power supply 80 as shown in Figure 7, the charge pump 92 is coupled to the DC power supply 80, such that the charge pump 92 is coupled between the DC power supply 80 and the second power filtering circuitry 88. Additionally, the RF modulation and control circuitry 28 provides the DC configuration control signal DCC and the envelope control signal ECS to the DC-DC control circuitry 90.

The DC-DC control circuitry 90 provides a charge pump buck control signal CPBS to the charge pump buck converter 84, provides a buck control signal BCS to the buck converter 86, and provides a charge pump control signal CPS to the charge pump 92. The charge pump buck control signal CPBS, the buck control signal BCS, or both may indicate which converter operating mode is selected. Further, the charge pump buck control signal CPBS, the buck control signal BCS, or both may provide the setpoint of the envelope power supply signal EPS as provided by the envelope control signal ECS. The charge pump buck control signal CPBS may indicate which pump buck operating mode is selected.

In one embodiment of the DC-DC converter 32, selection of the converter operating mode is made by the DC-DC control circuitry 90. In an alternate embodiment of the DC-DC converter 32, selection of the converter operating mode is made by the RF modulation and control circuitry 28 and may be communicated to the DC-DC converter 32 via the DC configuration control signal DCC. In an additional embodiment of the DC-DC converter 32, selection of the converter operating mode is made by the control circuitry 42

(Figure 4) and may be communicated to the DC-DC converter 32 via the DC configuration control signal DCC. In general, selection of the converter operating mode is made by control circuitry, which may be any of the DC-DC control circuitry 90, the RF modulation and control circuitry 28, and the control circuitry 42 (Figure 4).

In one embodiment of the DC-DC converter 32, selection of the pump buck operating mode is made by the DC-DC control circuitry 90. In an alternate embodiment of the DC-DC converter 32, selection of the pump buck operating mode is made by the RF modulation and control circuitry 28 and communicated to the DC-DC converter 32 via the DC configuration control signal DCC. In an additional embodiment of the DC-DC converter 32, selection of the pump buck operating mode is made by the control circuitry 42 (Figure 4) and communicated to the DC-DC converter 32 via the DC configuration control signal DCC. In general, selection of the pump buck operating mode is made by control circuitry, which may be any of the DC-DC control circuitry 90, the RF modulation and control circuitry 28, and the control circuitry 42 (Figure 4). As such, the control circuitry may select one of the pump buck pump-up operating mode and at least one other pump buck operating mode of the charge pump buck converter 84. The at least one other pump buck operating mode of the charge pump buck converter 84 may include any or all of the pump buck pump-down operating mode, the pump buck pump-even operating mode, and the pump buck bypass operating mode.

The charge pump 92 may operate in one of multiple bias supply pump operating modes. During a bias supply pump-up operating mode of the charge pump 92, the charge pump 92 receives and pumps-up the DC power supply signal DCPS to provide the bias power supply signal BPS, such that a voltage of the bias power supply signal BPS is greater than a voltage of the DC power supply signal DCPS. During a bias supply pump-down operating mode of the charge pump 92, the charge pump 92 pumps-down the DC power supply signal DCPS to provide the bias power supply signal BPS, such that a voltage of the bias power supply signal BPS is less than a voltage of the DC power supply signal DCPS. During a bias supply pump-even operating mode of the charge pump 92, the charge pump 92 pumps the DC power supply signal DCPS to provide the bias power supply signal BPS, such that a voltage of the bias power supply signal BPS is about equal to a voltage of the DC power supply signal DCPS. One embodiment of the DC-DC converter 32 includes a bias supply bypass operating mode of the charge pump 92, such that during the bias supply bypass operating mode, the charge pump 92 by-passes charge pump circuitry (not shown) using by-pass circuitry (not shown) to forward the DC power supply signal DCPS to provide the bias power supply signal BPS, such that a voltage of the bias power supply signal BPS is about equal to a voltage of the DC power supply signal DCPS. The charge pump control signal CPS may indicate which bias supply pump operating mode is selected.

In one embodiment of the charge pump 92, the bias supply pump operating modes include the bias supply pump-up operating mode, the bias supply pump-down operating mode, the bias supply pump-even operating mode, and the bias supply bypass operating mode. In an alternate embodiment of the charge pump 92, the bias supply pump-even operating mode is omitted. In an additional embodiment of the charge pump 92, the bias supply bypass operating mode is omitted. In another embodiment of the charge pump 92, the bias supply pump-down operating mode is omitted. In a further embodiment of the charge pump 92, any or all of the bias supply pump-up operating mode, the bias supply pump-down operating mode, the bias supply pump-even operating mode, and the bias supply bypass operating mode are omitted. In a supplemental embodiment of the charge pump 92, the charge pump 92 operates in only the bias supply pump-up operating mode. In an additional embodiment of the charge pump 92, the charge pump 92 operates in the bias supply pump-up operating mode and at least one other operating mode of the charge pump 92, which may include any or all of the bias supply pump-down operating mode, the bias supply pump-even operating mode, and the bias supply bypass operating mode.

In one embodiment of the DC-DC converter 32, selection of the bias supply pump operating mode is made by the DC-DC control circuitry 90. In an alternate embodiment of the DC-DC converter 32, selection of the bias supply pump operating mode is made by the RF modulation and control circuitry 28 and communicated to the DC-DC converter 32 via the DC configuration control signal DCC. In an additional embodiment of the DC-DC converter 32, selection of the bias supply pump operating mode is made by the control circuitry 42 (Figure 4) and communicated to the DC-DC converter 32 via the DC configuration control signal DCC. In general, selection of the bias supply pump operating mode is made by control circuitry, which may be any of the DC-DC control circuitry 90, the RF modulation and control circuitry 28, and the control circuitry 42 (Figure 4). As such, the control circuitry may select one of the bias supply pump-up operating mode and at least one other bias supply operating mode. The at least one other bias supply operating mode may include any or all of the bias supply pump-down operating mode, the bias supply pump-even operating mode, and the bias supply bypass operating mode.

The second power filtering circuitry 88 filters the bias power supply signal BPS. The second power filtering circuitry 88 may function as a lowpass filter by removing ripple, noise, and the like to provide the bias power supply signal BPS. As such, in one embodiment of the DC-DC converter 32, the bias power supply signal BPS is based on the DC power supply signal DCPS.

Regarding omission of the second inductive element L2, instead of the second inductive element L2 coupled between the buck converter 86 and the first power filtering circuitry 82 as shown in Figure 7, one end of the first inductive element L1 is coupled to both the charge pump buck converter 84 and the buck converter 86. As such, in the second converter operating mode or the third converter operating mode, the buck converter 86 may receive and buck convert the DC power supply signal DCPS to provide the second buck output signal SBO to the first inductive element L1. As such, in one embodiment of the charge pump buck converter 84, the second buck output signal SBO is based on the DC power supply signal DCPS. Further, the first inductive element L1 may function as a first energy transfer element of the buck converter 86 to transfer energy via the second buck output signal SBO to the first power filtering circuitry 82. In the first converter operating mode, the second converter operating mode, or the third converter operating mode, the first inductive element L1 and the first power filtering circuitry 82 receive and filter the first buck output signal FBO, the second buck output signal SBO, or both to provide the envelope power supply signal EPS.

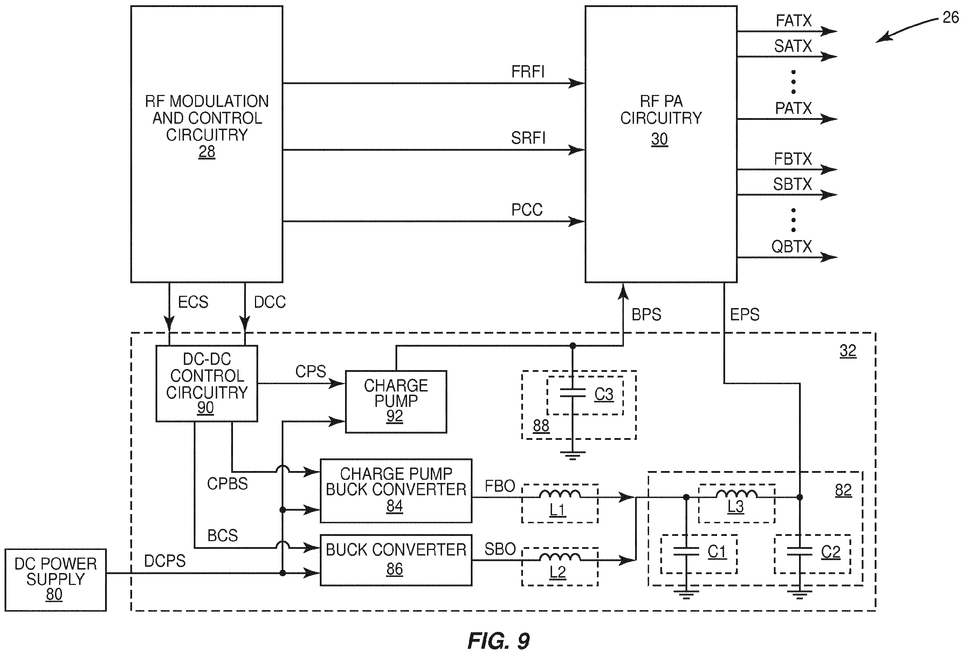

Figure 9 shows details of the DC-DC converter 32 illustrated in Figure 8 according to an alternate embodiment of the DC-DC converter 32. The DC-DC converter 32 illustrated in Figure 9 is similar to the DC-DC converter 32 illustrated in Figure 7, except the DC-DC converter 32 illustrated in Figure 9 shows details of the first power filtering circuitry 82 and the second power filtering circuitry 88. Further, the DC-DC converter 32 illustrated in Figure 9 includes the DC-DC control circuitry 90 and the charge pump 92 as shown in Figure 8.

The first power filtering circuitry 82 includes a first capacitive element C1, a second capacitive element C2, and a third inductive element L3. The first capacitive element C1 is coupled between one end of the third inductive element L3 and a ground. The second capacitive element C2 is coupled between an opposite end of the third inductive element L3 and ground. The one end of the third inductive element L3 is coupled to one end of the first inductive element L1. Further, the one end of the third inductive element L3 is coupled to one end of the second inductive element L2. In an additional embodiment of the DC-DC converter 32, the second inductive element L2 is omitted. The opposite end of the third inductive element L3 is coupled to the RF PA circuitry 30. As such, the opposite end of the third inductive element L3 and one end of the second capacitive element C2 provide the envelope power supply signal EPS. In an alternate embodiment of the first power filtering circuitry 82, the third inductive element L3, the second capacitive element C2, or both are omitted.

### Charge Pump Based PA Envelope Power Supply and Bias Power Supply

A summary of a charge pump based PA envelope power supply and bias power supply is presented, followed by a detailed description of the charge pump based PA envelope power supply according to one embodiment of the present disclosure. The present disclosure relates to a DC-DC converter, which includes a charge pump based RF PA envelope power supply and a charge pump based PA bias power supply. The DC-DC converter is coupled between RF PA circuitry and a DC power supply, such as a battery. As such, the PA envelope power supply provides an envelope power supply signal to the RF PA circuitry and the PA bias power supply provides a bias power supply signal to the RF PA circuitry. Both the PA envelope power supply and the PA bias power supply receive power via a DC power supply signal from the DC power supply. The PA envelope power supply includes a charge pump buck converter and the PA bias power supply includes a charge pump.

By using charge pumps, a voltage of the envelope power supply signal may be greater than a voltage of the DC power supply signal, a voltage of the bias power supply signal may be greater than the voltage of the DC power supply signal, or both. Providing boosted voltages may provide greater flexibility in providing envelope power for amplification and in biasing the RF PA circuitry. The charge pump buck converter provides the functionality of a charge pump feeding a buck converter. However, the charge pump buck converter requires fewer switching elements than a charge pump feeding a buck converter by sharing certain switching elements.

The charge pump buck converter is coupled between the DC power supply and the RF PA circuitry. The charge pump is coupled between the DC power supply and the RF PA circuitry. In one embodiment of the PA envelope power supply, the PA envelope power supply further includes a buck converter coupled between the DC power supply and the RF PA circuitry. The PA envelope power supply may operate in one of a first envelope operating mode and a second envelope operating mode. During the first envelope operating mode, the charge pump buck converter is active, and the buck converter is inactive. Conversely, during the second envelope operating mode, the charge pump buck converter is inactive, and the buck converter is active. As such, the PA envelope power supply may operate in the first envelope operating mode when a voltage above the voltage of the DC power supply signal may be needed. Conversely, the PA envelope power supply may operate in the second envelope operating mode when a voltage above the voltage of the DC power supply signal is not needed.

In one embodiment of the charge pump buck converter, the charge pump buck converter operates in one of a pump buck pump-up operating mode and at least one other pump buck operating mode, which may include any or all of a pump buck pump-down operating mode, a pump buck pump-even operating mode, and a pump buck bypass operating mode. In one embodiment of the charge pump, the charge pump operates in one of a bias supply pump-up operating mode and at least one other bias supply operating mode, which may include any or all of a bias supply pump-down operating mode, a bias supply pump-even operating mode, and a bias supply bypass operating mode.

In one embodiment of the RF PA circuitry, the RF PA circuitry has an RF PA, which is biased based on the bias power supply signal and receives the envelope power supply signal to provide power for amplification. In one embodiment of the RF PA circuitry, the RF PA has a final stage that receives a final bias signal to bias the final stage, such that the final bias signal is based on the bias power supply signal. Additionally, the DC-DC converter provides the envelope power supply signal to the RF PA, which uses the envelope power supply signal to provide power for amplification. In one embodiment of the RF PA circuitry, the RF PA circuitry includes PA bias circuitry, which receives the bias power supply signal to provide the final bias signal. In one embodiment of the PA bias circuitry, the PA bias circuitry includes a final stage IDAC to receive and use the bias power supply signal in a digital-to-analog conversion to provide the final bias signal.

In one embodiment of the RF PA circuitry, the RF PA circuitry includes a first RF PA and a second RF PA, which may include a first final stage and a second final stage, respectively. The first RF PA is used to receive and amplify a highband RF input signal and the second RF PA is used to receive and amplify a lowband RF input signal. The RF PA circuitry may operate in one of a first PA operating mode and a second PA operating mode, such that during the first PA operating mode, the first RF PA is active and the second RF PA is disabled. Conversely, during the second PA operating mode, the first RF PA is disabled and the second RF PA is active. The PA bias circuitry includes the final stage IDAC and a final stage multiplexer. The final stage IDAC receives and uses the bias power supply signal in a digital-to-analog conversion to provide a final stage bias signal to the final stage multiplexer. During the first PA operating mode, the final stage multiplexer receives and forwards the final stage bias signal to provide a first final bias signal to the first RF PA to bias the first final stage. During the second PA operating mode, the final stage multiplexer receives and forwards the final stage bias signal to provide a second final bias signal to the second RF PA to bias the second final stage.

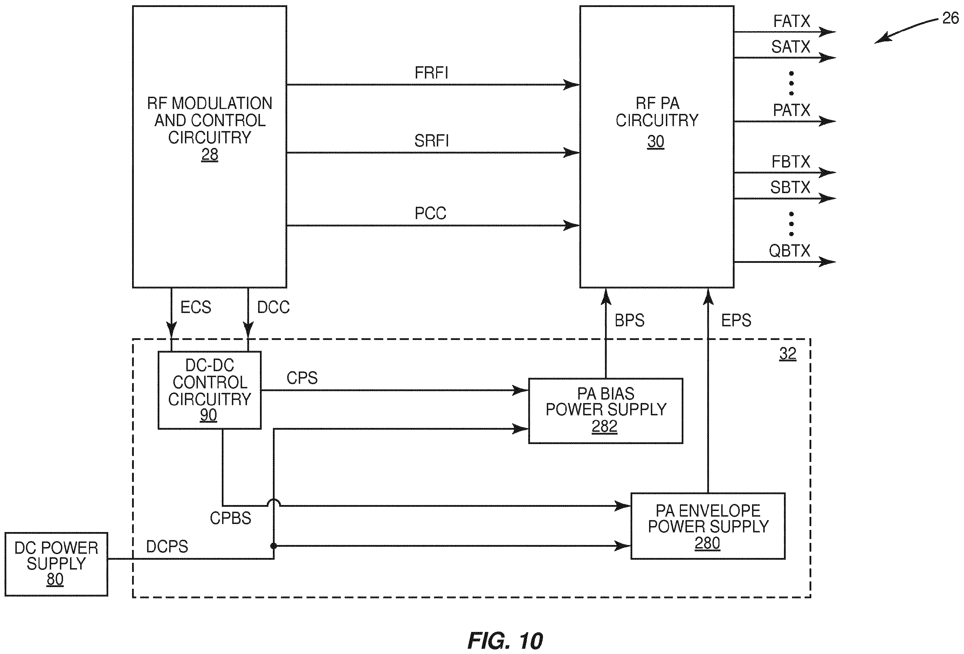

Figure 10 shows the RF communications system 26 according to one embodiment of the RF communications system 26. The RF communications system 26 illustrated in Figure 10 is similar to the RF communications system 26 illustrated in Figure 8; except in the RF communications system 26 illustrated in Figure 10; the DC-DC converter 32 shows a PA envelope power supply 280 instead of showing the first power filtering circuitry 82, the charge pump buck converter 84, the buck converter 86, and the first inductive element L1; and shows a PA bias power supply 282 instead of showing the second power filtering circuitry 88 and the charge pump 92. The PA envelope power supply 280 is coupled to the RF PA circuitry 30 and the PA bias power supply 282 is coupled to the RF PA circuitry 30. Further, the PA envelope power supply 280 is coupled to the DC power supply 80 and the PA bias power supply 282 is coupled to the DC power supply 80.

The PA bias power supply 282 receives the DC power supply signal DCPS from the DC power supply 80 and provides the bias power supply signal BPS based on DC-DC conversion of the DC power supply signal DCPS. The PA envelope power supply 280 receives the DC power supply signal DCPS from the DC power supply 80 and provides the envelope power supply signal EPS based on DC-DC conversion of the DC power supply signal DCPS.

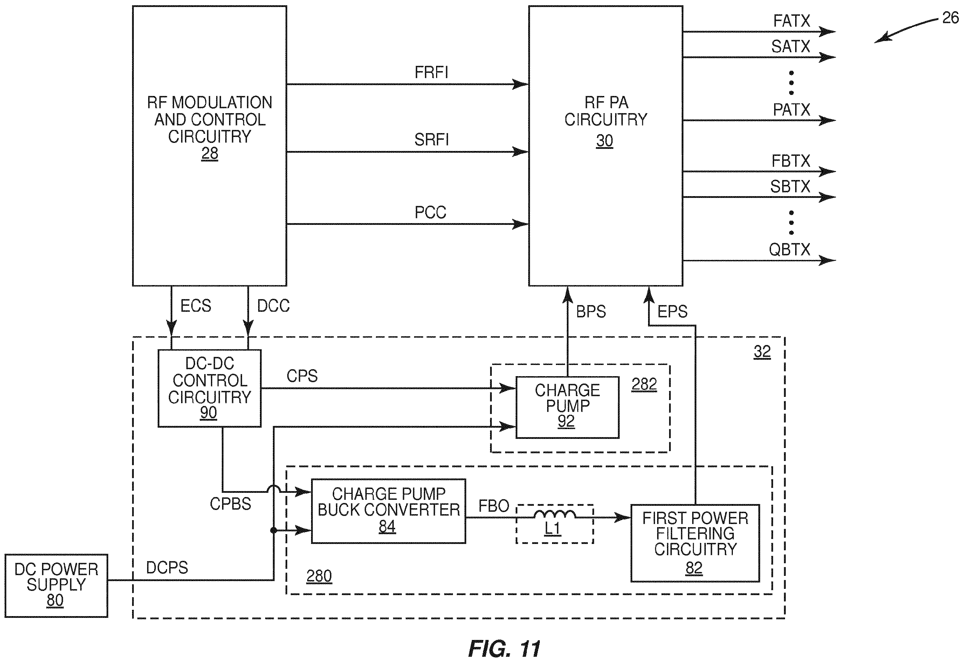

Figure 11 shows details of the PA envelope power supply 280 and the PA bias power supply 282 illustrated in Figure 10 according to one embodiment of the PA envelope power supply 280 and the PA bias power supply 282. The PA envelope power supply 280 includes the charge pump buck converter 84, the first inductive element L1, and the first power filtering circuitry 82. The PA bias power supply 282 includes the charge pump 92. In general, the charge pump buck converter 84 is coupled between the RF PA circuitry 30 and the DC power supply 80. Specifically, the first inductive element L1 is coupled between the charge pump buck converter 84 and the first power filtering circuitry 82. The charge pump buck converter 84 is coupled between the DC power supply 80 and the first inductive element L1. The first power filtering circuitry 82 is coupled between the first inductive element L1 and the RF PA circuitry 30. The charge pump 92 is coupled between the RF PA circuitry 30 and the DC power supply 80.

The charge pump buck converter 84 receives and converts the DC power supply signal DCPS to provide the first buck output signal FBO, such that the envelope power supply signal EPS is based on the first buck output signal FBO. The charge pump 92 receives and charge pumps the DC power supply signal DCPS to provide the bias power supply signal BPS.

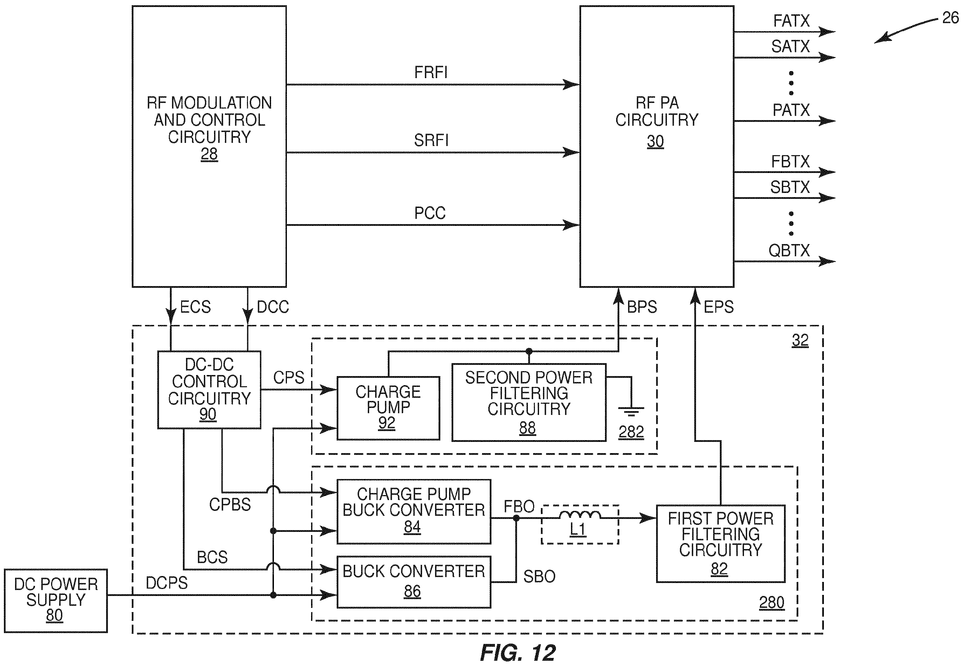

Figure 12 shows details of the PA envelope power supply 280 and the PA bias power supply 282 illustrated in Figure 10 according to an alternate embodiment of the PA envelope power supply 280 and the PA bias power supply 282. The PA envelope power supply 280 illustrated in Figure 12 is similar to the PA envelope power supply 280 illustrated in Figure 11, except the PA envelope power supply 280 illustrated in Figure 12 further includes the buck converter 86 coupled across the charge pump buck converter 84. The PA bias power supply 282 illustrated in Figure 12 is similar to the PA bias power supply 282 illustrated in Figure 11, except the PA bias power supply 282 illustrated in Figure 12 further includes the second power filtering circuitry 88 coupled between the RF PA circuitry 30 and ground.

In one embodiment of the DC-DC converter 32, the DC-DC converter 32 operates in one of multiple converter operating modes, which include the first converter operating mode, the second converter operating mode, and the third converter operating mode. In an alternate embodiment of the DC-DC converter 32, the DC-DC converter 32 operates in one of the first converter operating mode and the second converter operating mode. In the first converter operating mode, the charge pump buck converter 84 is active, such that the envelope power supply signal EPS is based on the DC power supply signal DCPS via the charge pump buck converter 84. In the first converter operating mode, the buck converter 86 is inactive and does not contribute to the envelope power supply signal EPS. In the second converter operating mode, the buck converter 86 is active, such that the envelope power supply signal EPS is based on the DC power supply signal DCPS via the buck converter 86. In the second converter operating mode, the charge pump buck converter 84 is inactive, such that the charge pump buck converter 84 does not contribute to the envelope power supply signal EPS. In the third converter operating mode, the charge pump buck converter 84 and the buck converter 86 are active, such that either the charge pump buck converter 84; the buck converter 86; or both may contribute to the envelope power supply signal EPS. As such, in the third converter operating mode, the envelope power supply signal EPS is based on the DC power supply signal DCPS via the charge pump buck converter 84, via the buck converter 86, or both.

In one embodiment of the DC-DC converter 32, selection of the converter operating mode is made by the DC-DC control circuitry 90. In an alternate embodiment of the DC-DC converter 32, selection of the converter operating mode is made by the RF modulation and control circuitry 28 and may be communicated to the DC-DC converter 32 via the DC configuration control signal DCC. In an additional embodiment of the DC-DC converter 32, selection of the converter operating mode is made by the control circuitry 42 (Figure 4) and may be communicated to the DC-DC converter 32 via the DC configuration control signal DCC. In general, selection of the converter operating mode is made by control circuitry, which may be any of the DC-DC control circuitry 90, the RF modulation and control circuitry 28, and the control circuitry 42 (Figure 4).

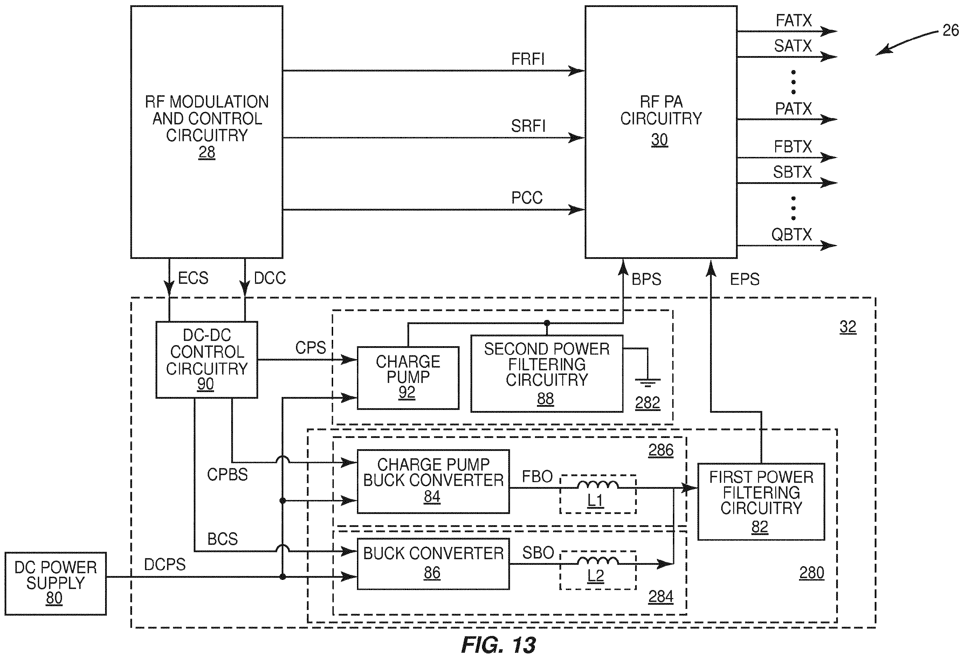

Figure 13 shows details of the PA envelope power supply 280 and the PA bias power supply 282 illustrated in Figure 10 according to an additional embodiment of the PA envelope power supply 280 and the PA bias power supply 282. The PA envelope power supply 280 illustrated in Figure 13 is similar to the PA envelope power supply 280 illustrated in Figure 11, except the PA envelope power supply 280 illustrated in Figure 13 further includes the buck converter 86 and the second inductive element L2 coupled in series to form a first series coupling 284. The charge pump buck converter 84 and the first inductive element L1 are coupled in series to form a second series coupling 286, which is coupled across the first series coupling 284. The PA bias power supply 282 illustrated in Figure 12 is similar to the PA bias power supply 282 illustrated in Figure 11, except the PA bias power supply 282 illustrated in Figure 12 further includes the second power filtering circuitry 88 coupled between the RF PA circuitry 30 and ground.

In the first converter operating mode, the charge pump buck converter 84 is active, such that the envelope power supply signal EPS is based on the DC power supply signal DCPS via the charge pump buck converter 84, and the first inductive element L1. In the first converter operating mode, the buck converter 86 is inactive and does not contribute to the envelope power supply signal EPS. In the second converter operating mode, the buck converter 86 is active, such that the envelope power supply signal EPS is based on the DC power supply signal DCPS via the buck converter 86 and the second inductive element L2. In the second converter operating mode, the charge pump buck converter 84 is inactive, such that the charge pump buck converter 84 does not contribute to the envelope power supply signal EPS. In the third converter operating mode, the charge pump buck converter 84 and the buck converter 86 are active, such that either the charge pump buck converter 84; the buck converter 86; or both may contribute to the envelope power supply signal EPS. As such, in the third converter operating mode, the envelope power supply signal EPS is based on the DC power supply signal DCPS either via the charge pump buck converter 84, and the first inductive element L1; via the buck converter 86 and the second inductive element L2; or both.

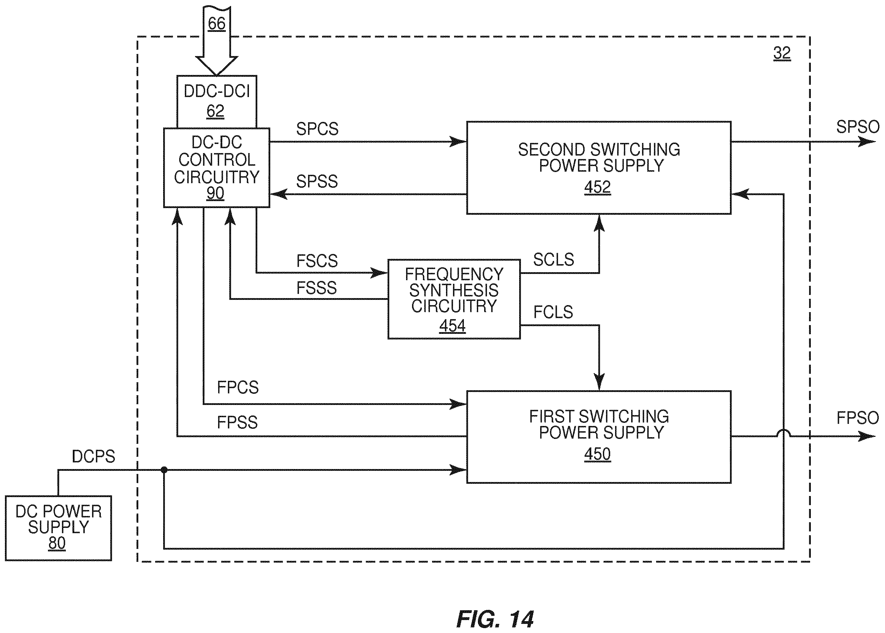

Figure 14 shows the DC-DC converter 32 according to one embodiment of the DC-DC converter 32. In one embodiment of the DC-DC converter 32, the DC-DC converter 32 illustrated in Figure 14 is used as the DC-DC converter 32 illustrated in Figure 5. The DC-DC converter 32 includes the DC-DC converter DCI 62, the DC-DC control circuitry 90, a first switching power supply 450, a second switching power supply 452, and frequency synthesis circuitry 454. The DC-DC converter DCI 62 is coupled between the digital communications bus 66 and the DC-DC control circuitry 90. The DC power supply 80 provides the DC power supply signal DCPS to the first switching power supply 450 and the second switching power supply 452.

The DC-DC control circuitry 90 provides a first power supply control signal FPCS to the first switching power supply 450, a second power supply control signal SPCS to the second switching power supply 452, and a frequency synthesis control signal FSCS to the frequency synthesis circuitry 454. The first switching power supply 450 provides a first power supply status signal FPSS to the DC-DC control circuitry 90. The second switching power supply 452 provides a second power supply status signal SPSS to the DC-DC control circuitry 90. The frequency synthesis circuitry 454 provides a frequency synthesis status signal FSSS to the DC-DC control circuitry 90.

The frequency synthesis circuitry 454 provides a first clock signal FCLS to the first switching power supply 450 and a second clock signal SCLS to the second switching power supply 452. The first clock signal FCLS has a first frequency and the second clock signal SCLS has a second frequency. The second clock signal SCLS is phase-locked to the first clock signal FCLS. The first switching power supply 450 receives and converts the DC power supply signal DCPS to provide a first switching power supply output signal FPSO using the first clock signal FCLS, such that a switching frequency of the first switching power supply 450 is equal to the first frequency. The second switching power supply 452 receives and converts the DC power supply signal DCPS to provide a second switching power supply output signal SPSO using the second clock signal SCLS, such that a switching frequency of the second switching power supply 452 is equal to the second frequency.

In one embodiment of the frequency synthesis circuitry 454, the first frequency divided by the second frequency is about equal to a positive integer. In one embodiment of the frequency synthesis circuitry 454, the first frequency divided by the second frequency is about equal to a first positive integer divided by a second positive integer. In one embodiment of the first switching power supply 450, the first switching power supply 450 is a charge pump buck power supply. In one embodiment of the second switching power supply 452, the second switching power supply 452 is a charge pump power supply.

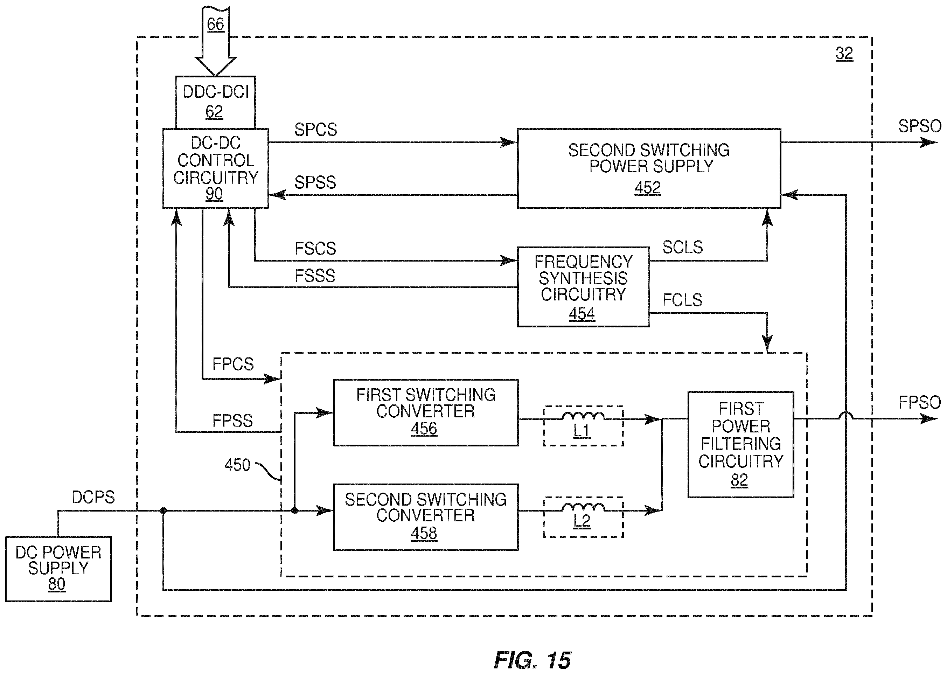

Figure 15 shows details of the first switching power supply 450 illustrated in Figure 14 according to one embodiment of the first switching power supply 450. The first switching power supply 450 includes a first switching converter 456, a second switching converter 458, the first power filtering circuitry 82, the first inductive element L1, and the second inductive element L2. The first switching converter 456 is coupled between the DC power supply 80 and the first inductive element L1. The first inductive element L1 is coupled between the first switching converter 456 and the first power filtering circuitry 82. The second switching converter 458 is coupled between the DC power supply 80 and the second inductive element L2. The second inductive element L2 is coupled between the second switching converter 458 and the first power filtering circuitry 82. The first power filtering circuitry 82 provides the first switching power supply output signal FPSO.

During the first converter operating mode, the first switching converter 456 is active and the second switching converter 458 is inactive, such that the first switching converter 456 receives and converts the DC power supply signal DCPS to provide the first switching power supply output signal FPSO via the first inductive element L1 and the first power filtering circuitry 82. During the second converter operating mode, the first switching converter 456 is inactive and the second switching converter 458 is active, such that the second switching converter 458 receives and converts the DC power supply signal DCPS to provide the first switching power supply output signal FPSO via the second inductive element L2 and the first power filtering circuitry 82.

In an alternate embodiment of the first switching power supply 450, the second switching converter 458 and the second inductive element L2 are omitted. In an additional embodiment of the first switching power supply 450, the second inductive element L2 is omitted, such that the second switching converter 458 is coupled across the first switching converter 456.

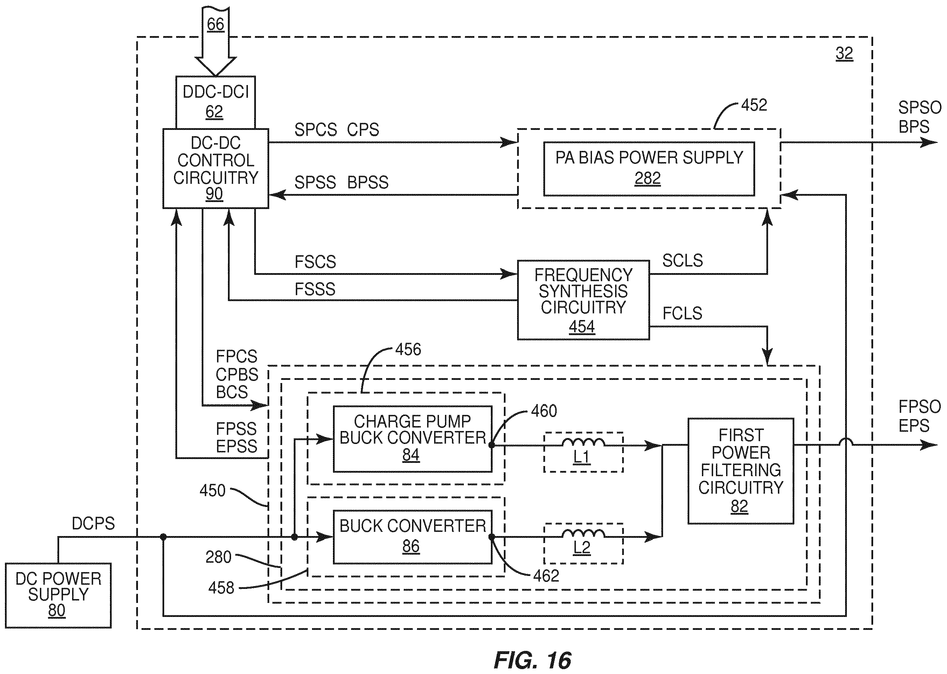

Figure 16 shows details of the first switching power supply 450 and the second switching power supply 452 illustrated in Figure 15 according to an alternate embodiment of the first switching power supply 450 and one embodiment of the second switching power supply 452. The first switching power supply 450 is the PA envelope power supply 280. The second switching power supply 452 is the PA bias power supply 282. As such, in one embodiment of the second switching power supply 452, the second switching power supply 452 includes the charge pump 92 (Figure 8), which receives and converts the DC power supply signal DCPS to provide the second switching power supply output signal SPSO. The first switching converter 456 is the charge pump buck converter 84. The second switching converter 458 is the buck converter 86. The charge pump buck converter 84 has a first output inductance node 460. The buck converter 86 has a second output inductance node 462. The first inductive element L1 is coupled between the first output inductance node 460 and the first power filtering circuitry 82. The second inductive element L2 is coupled between the second output inductance node 462 and the first power filtering circuitry 82.

The frequency synthesis circuitry 454 provides the first clock signal FCLS to the PA envelope power supply 280 and the second clock signal SCLS to the PA bias power supply 282. A switching frequency of the PA envelope power supply 280 is equal to the first frequency. A switching frequency of the PA bias power supply 282 is equal to the second frequency. The first switching power supply output signal FPSO is the envelope power supply signal EPS. The second switching power supply output signal SPSO is the bias power supply signal BPS. The first power supply control signal FPCS provides the charge pump buck control signal CPBS and the buck control signal BCS. The second power supply control signal SPCS is the charge pump control signal CPS. The first power supply status signal FPSS is the envelope power supply status signal EPSS. The second power supply status signal SPSS is the bias power supply status signal BPSS.

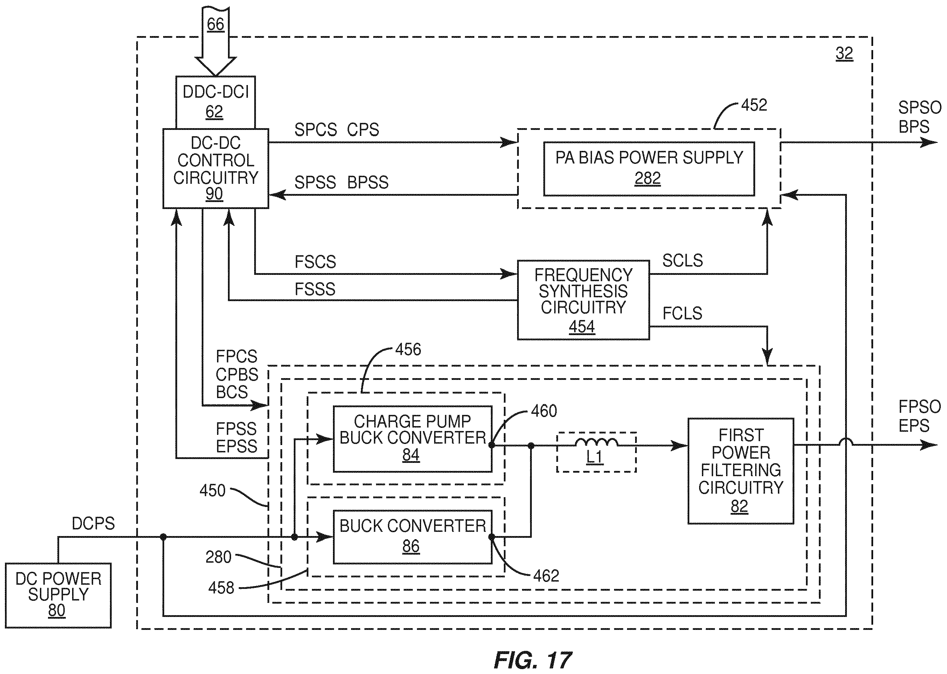

Figure 17 shows details of the first switching power supply 450 and the second switching power supply 452 illustrated in Figure 15 according to an additional embodiment of the first switching power supply 450 and one embodiment of the second switching power supply 452. The first switching power supply 450 illustrated in Figure 17 is similar to the first switching power supply 450 illustrated in Figure 16, except in the first switching power supply 450 illustrated in Figure 17, the second inductive element L2 is omitted. As such, the first output inductance node 460 is coupled to the second output inductance node 462. Specifically, the first output inductance node 460 may be directly coupled to the second output inductance node 462.

### Voltage Compatible Charge Pump Buck and Buck Power Supplies

A summary of voltage compatible charge pump buck and buck power supplies is followed by a summary of dual inductive element charge pump buck and buck power supplies and a summary of a DC-DC converter using continuous and discontinuous conduction modes. The summaries are followed by a detailed description of the voltage compatible charge pump buck and buck power supplies and the dual inductive element charge pump buck and buck power supplies according to one embodiment of the present disclosure. The present disclosure relates to a flexible DC-DC converter, which includes a charge pump buck power supply and a buck power supply. The charge pump buck power supply and the buck power supply are voltage compatible with one another at respective output inductance nodes to provide flexibility. In one embodiment of the DC-DC converter, capacitances at the output inductance nodes are at least partially isolated from one another by using at least an isolating inductive element between the output inductance nodes to increase efficiency. In an alternate embodiment of the DC-DC converter, the output inductance nodes are coupled to one another, such that the charge pump buck power supply and the buck power supply share a first inductive element, thereby eliminating the isolating inductive element, which reduces size and cost but may also reduce efficiency. In both embodiments, the charge pump buck power supply and the buck power supply share an energy storage element. Specifically, the charge pump buck power supply includes a charge pump buck converter having a first output inductance node, a first inductive element, and the energy storage element, such that the first inductive element is coupled between the first output inductance node and the energy storage element. The buck power supply includes a buck converter having a second output inductance node, and the energy storage element. The buck power supply at the second output inductance node is voltage compatible with the charge pump buck power supply at the first output inductance node to provide flexibility.

Only one of the charge pump buck power supply and the buck power supply is active at any one time. As such, either the charge pump buck power supply or the buck power supply receives and converts a DC power supply signal from a DC power supply to provide a first switching power supply output signal to a load based on a setpoint. In one embodiment of the energy storage element, the energy storage element is a capacitive element. In one embodiment of the DC-DC converter, the buck power supply further includes the first inductive element and a second inductive element, which is coupled between the first output inductance node and the second output inductance node, such that the charge pump buck power supply and the buck power supply further share the first inductive element. In another embodiment of the DC-DC converter, the buck power supply further includes the second inductive element, which is coupled between the second output inductance node and the energy storage element. In an alternate embodiment of the DC-DC converter, the first output inductance node is coupled to the second output inductance node and the buck power supply further includes the first inductive element, such that the charge pump buck power supply and the buck power supply further share the first inductive element.

The charge pump buck converter combines the functionality of a charge pump with the functionality of a buck converter. However, the charge pump buck converter uses fewer switching elements than a separate charge pump and buck converter by using common switching elements for both charge pump and buck converter functionalities. As such, the charge pump buck power supply is capable of providing an output voltage that is greater than a voltage of the DC power supply signal. Conversely, the buck power supply is only capable of providing an output voltage that is about equal to or less than the voltage of the DC power supply signal. However, for the buck power supply to be voltage compatible with the charge pump buck power supply, the buck power supply must not be damaged or function improperly in the presence of a voltage at the second output inductance node that is equivalent to a voltage at the first output inductance node during normal operation of the charge pump buck power supply.

In one embodiment of the DC-DC converter, during a first converter operating mode, the charge pump buck power supply receives and converts the DC power supply signal to provide the first switching power supply output signal, and the buck power supply is disabled. During a second converter operating mode, the buck power supply receives and converts the DC power supply signal to provide the first switching power supply output signal, and the charge pump buck power supply is disabled. The setpoint is based on a desired voltage of the first switching power supply output signal.

In one embodiment of the DC-DC converter, selection of either the first converter operating mode or the second converter operating mode is based on a voltage of the DC power supply signal and the setpoint. The first converter operating mode is selected when the desired voltage of the first switching power supply output signal is greater than the voltage of the DC power supply signal. In one embodiment of the DC-DC converter, selection of either the first converter operating mode or the second converter operating mode is further based on a load current of the load. The second converter operating mode is selected when the desired voltage of the first switching power supply output signal is less than the voltage of the DC power supply signal and the load current is less than a load current threshold.

In a first exemplary embodiment of the DC-DC converter, selection of either the first converter operating mode or the second converter operating mode is further based on maximizing efficiency of the DC-DC converter. In a second exemplary embodiment of the DC-DC converter, selection of either the first converter operating mode or the second converter operating mode is further based on exceeding a minimum acceptable efficiency of the DC-DC converter. In a third exemplary embodiment of the DC-DC converter, selection of either the first converter operating mode or the second converter operating mode is further based on exceeding a desired efficiency of the DC-DC converter. In one embodiment of the DC-DC converter, the DC-DC converter further includes a charge pump, which receives and converts the DC power supply signal to provide a second switching power supply output signal. In one embodiment of the DC-DC converter, the first switching power supply output signal is an envelope power supply signal for a first RF power amplifier (PA) and the second switching power supply output signal is a bias power supply signal used for biasing the first RF PA.

As previously mentioned, in one embodiment of the DC-DC converter, the first output inductance node is coupled to the second output inductance node. During the first converter operating mode, the charge pump buck converter may boost the voltage of the DC power supply signal significantly, such that a voltage at the first and second output inductance nodes may be significantly higher than the voltage of the DC power supply signal. As a result, even though the buck converter is disabled during the first converter operating mode, the buck converter must be able to withstand the boosted voltage at the second output inductance node. In an exemplary embodiment of the DC-DC converter, the voltage at the first and second output inductance nodes is equal to about 11 volts and a breakdown voltage of individual switching elements in the buck converter is equal to about 7 volts.

To withstand boosted voltage at the second output inductance node, in one embodiment of the buck converter, the buck converter includes multiple shunt buck switching elements and multiple series buck switching elements. The shunt buck switching elements are coupled in series between the second output inductance node and a ground, and the series buck switching elements are coupled in series between the DC power supply and the first output inductance node. In one embodiment of the buck converter, the series buck switching elements are configured in a cascode arrangement.

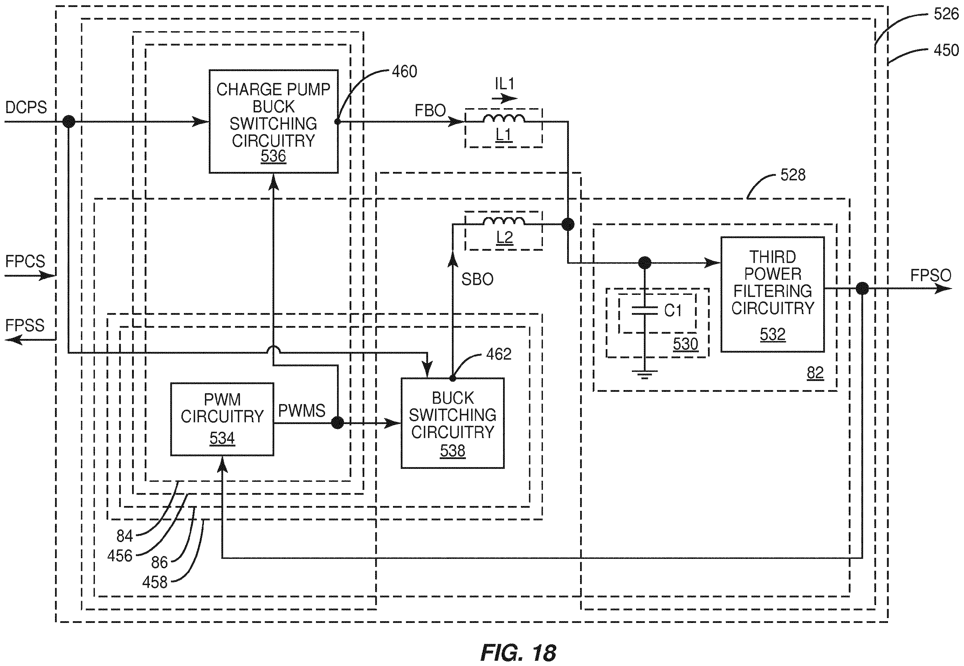

Figure 18 shows details of the first switching power supply 450 illustrated in Figure 16 according to one embodiment of the first switching power supply 450. The first switching power supply 450 includes a charge pump buck power supply 526 and a buck power supply 528. The charge pump buck power supply 526 includes the first switching converter 456, the first inductive element L1, and the first power filtering circuitry 82. The buck power supply 528 includes the second switching converter 458, the second inductive element L2 and the first power filtering circuitry 82. The first switching converter 456 is the charge pump buck converter 84, which includes pulse width modulation (PWM) circuitry 534 and charge pump buck switching circuitry 536. The second switching converter 458 is the buck converter 86, which includes the PWM circuitry 534 and buck switching circuitry 538. As such, the charge pump buck converter 84 and the buck converter 86 share the PWM circuitry 534. Further, the charge pump buck power supply 526 and the buck power supply 528 share the PWM circuitry 534 and the first power filtering circuitry 82.

The first power filtering circuitry 82 includes an energy storage element 530 and third power filtering circuitry 532. In one embodiment of the energy storage element 530, the energy storage element 530 is the first capacitive element C1. The charge pump buck switching circuitry 536 includes the first output inductance node 460 and the buck switching circuitry 538 includes the second output inductance node 462. As such, the charge pump buck converter 84 has the first output inductance node 460 and the buck converter 86 has the second output inductance node 462. In this regard, the charge pump buck power supply 526 includes the charge pump buck converter 84, the first inductive element L1, and the energy storage element 530. The buck power supply 528 includes the buck converter 86, the second inductive element L2, and the energy storage element 530.

The first inductive element L1 is coupled between the first switching converter 456 and the energy storage element 530. The second inductive element L2 is coupled between the second switching converter 458 and the energy storage element 530. Specifically, the first inductive element L1 is coupled between the first output inductance node 460 and the energy storage element 530, and the second inductive element L2 is coupled between the second output inductance node 462 and the energy storage element 530. In this regard, the charge pump buck power supply 526 and the buck power supply 528 share the energy storage element 530. The charge pump buck converter 84 and the first inductive element L1 are coupled in series between the DC power supply 80 (Figure 16) and the energy storage element 530. The buck converter 86 and the second inductive element L2 are coupled in series between the DC power supply 80 (Figure 16) and the energy storage element 530.

As previously mentioned, in one embodiment of the first switching power supply 450, during the first converter operating mode, the charge pump buck power supply 526 receives and converts the DC power supply signal DCPS from the DC power supply 80 (Figure 16) to provide the first switching power supply output signal FPSO to a load, such as the RF PA circuitry 30 (Figure 5), based on a setpoint. During the first converter operating mode, the buck power supply 528 is disabled. During the second converter operating mode, the buck power supply 528 receives and converts the DC power supply signal DCPS from the DC power supply 80 (Figure 16) to provide the first switching power supply output signal FPSO to the load, such as the RF PA circuitry 30 (Figure 5), based on the setpoint. During the second converter operating mode, the charge pump buck power supply 526 is disabled. The setpoint is based on a desired voltage of the first switching power supply output signal FPSO.

During the first converter operating mode, the first inductive element L1 and the first capacitive element C1 form a lowpass filter, such that the charge pump buck switching circuitry 536 provides the first buck output signal FBO to the lowpass filter, which receives and filters the first buck output signal FBO to provide a filtered first buck output signal to the third power filtering circuitry 532. The third power filtering circuitry 532 receives and filters the filtered first buck output signal to provide the first switching power supply output signal FPSO. During the second converter operating mode, the second inductive element L2 and the first capacitive element C1 form a lowpass filter, such that the buck switching circuitry 538 provides the second buck output signal SBO to the lowpass filter, which receives and filters the second buck output signal SBO to provide a filtered second buck output signal to the third power filtering circuitry 532. The third power filtering circuitry 532 receives and filters the filtered second buck output signal to provide the first switching power supply output signal FPSO.

In one embodiment of the first switching power supply 450, selection of either the first converter operating mode or the second converter operating mode is based on a voltage of the DC power supply signal DCPS and the setpoint. As such, the first converter operating mode is selected when the desired voltage of the first switching power supply output signal FPSO is greater than the voltage of the DC power supply signal DCPS. In an alternate embodiment of the first switching power supply 450, selection of either the first converter operating mode or the second converter operating mode is based on the voltage of the DC power supply signal DCPS, the setpoint, and a load current of the load. As such, the second converter operating mode may be selected when the desired voltage of the first switching power supply output signal FPSO is less than the voltage of the DC power supply signal DCPS and the load current is less than a load current threshold. Selection of either the first converter operating mode or the second converter operating mode may be further based on maximizing efficiency.

In one embodiment of the first switching power supply 450, the control circuitry 42 (Figure 5) provides the setpoint to the DC-DC control circuitry 90 (Figure 16), which selects either the first converter operating mode or the second converter operating mode. As such, the DC configuration control signal DCC (Figure 5) is based on the setpoint. In an alternate embodiment of the first switching power supply 450, the control circuitry 42 (Figure 5) selects either the first converter operating mode or the second converter operating mode and provides the setpoint and the selection of either the first converter operating mode or the second converter operating mode to the DC-DC control circuitry 90 (Figure 16). As such, the DC configuration control signal DCC (Figure 5) is based on the setpoint and the selection of either the first converter operating mode or the second converter operating mode. Further, the DC-DC control circuitry 90 (Figure 16) provides the first power supply control signal FPCS to the first switching power supply 450. As such, the first power supply control signal FPCS is based on the setpoint and the selection of either the first converter operating mode or the second converter operating mode.

The PWM circuitry 534 receives the setpoint and the first switching power supply output signal FPSO. The PWM circuitry 534 provides a PWM signal PWMS to the charge pump buck switching circuitry 536 and the buck switching circuitry 538 based on a difference between the setpoint and the first switching power supply output signal FPSO. The PWM signal PWMS has a duty-cycle based on the difference between the setpoint and the first switching power supply output signal FPSO. During the first converter operating mode, a duty-cycle of the charge pump buck switching circuitry 536 is based on the duty-cycle of the PWM signal PWMS. During the second converter operating mode, a duty-cycle of the buck switching circuitry 538 is based on the duty-cycle of the PWM signal PWMS. In this regard, during the first converter operating mode, the PWM circuitry 534, the charge pump buck switching circuitry 536, the first inductive element L1, the first capacitive element C1, and the third power filtering circuitry 532 form a control loop to regulate the first switching power supply output signal FPSO based on the setpoint. Similarly, during the second converter operating mode, the PWM circuitry 534, the buck switching circuitry 538, the second inductive element L2, the first capacitive element C1, and the third power filtering circuitry 532 form a control loop to regulate the first switching power supply output signal FPSO based on the setpoint.

In one embodiment of the charge pump buck power supply 526 and the buck power supply 528, the buck power supply 528 at the second output inductance node 462 is voltage compatible with the charge pump buck power supply 526 at the first output inductance node 460. Such voltage compatibility between the charge pump buck power supply 526 and the buck power supply 528 provides flexibility and may allow the charge pump buck converter 84 and the buck converter 86 to be used in different configurations. One example of a different configuration is the elimination of the second inductive element L2, such that the first output inductance node 460 is directly coupled to the second output inductance node 462.

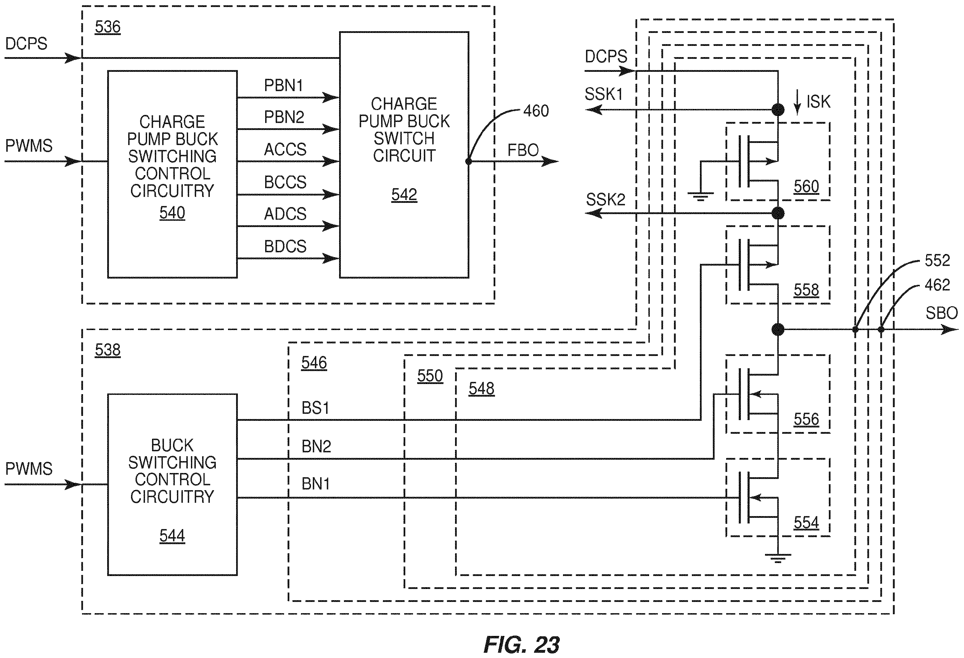

As previously mentioned, the first switching power supply 450 receives and converts the DC power supply signal DCPS to provide the first switching power supply output signal FPSO based on the setpoint. The first switching power supply 450 includes the first switching converter 456, the first inductive element L1, the energy storage element 530, and switching control circuitry. A portion of charge pump buck switching control circuitry 540 (Figure 23), a portion of buck switching control circuitry 544 (Figure 23), or both provides the switching control circuitry. In one embodiment of the DC-DC converter 32 (Figure 16), the DC-DC control circuitry 90 (Figure 16) provides indication of selection of one of the CCM and the DCM to the first switching power supply 450 via the first power supply control signal FPCS. The selection of the one of the CCM and the DCM is based on a rate of change of the setpoint. During the CCM, the switching control circuitry allows energy to flow from the energy storage element 530 to the first inductive element L1. During the DCM, the switching control circuitry does not allow energy to flow from the energy storage element 530 to the first inductive element L1. The rate of change of the setpoint may be a negative rate of change of the setpoint.

The first inductive element L1 has a first inductive element current IL1, which is positive when energy flows from the first inductive element L1 to the energy storage element 530, and is negative when energy flows from the energy storage element 530 to the first inductive element L1. In one embodiment of the DC-DC converter 32 (Figure 16), the control circuitry 42 (Figure 5) provides the setpoint to the DC-DC control circuitry 90 (Figure 16) via the envelope control signal ECS (Figure 5) and the DC-DC control circuitry 90 (Figure 16) makes the selection of the one of the CCM and the DCM. In an alternate embodiment of the DC-DC converter 32 (Figure 16), the control circuitry 42 (Figure 5) provides the setpoint to the DC-DC control circuitry 90 (Figure 16) via the envelope control signal ECS (Figure 5), and the control circuitry 42 (Figure 5) makes the selection of the one of the CCM and the DCM and provides indication of the selection to the DC-DC control circuitry 90 (Figure 16) via the DC configuration control signal DCC (Figure 5). As such, the DC configuration control signal DCC (Figure 5) is based on the selection of the one of the CCM and the DCM.

In one embodiment of the DC-DC converter 32 (Figure 16), during the first converter operating mode and during the CCM, the switching control circuitry allows energy to flow from the energy storage element 530 to the first inductive element L1. During the first converter operating mode and during the DCM, the switching control circuitry does not allow energy to flow from the energy storage element 530 to the first inductive element L1. During the second converter operating mode and during the CCM, the switching control circuitry allows energy to flow from the energy storage element 530 to the second inductive element L2. During the second converter operating mode and during the DCM, the switching control circuitry does not allow energy to flow from the energy storage element 530 to the second inductive element L2.

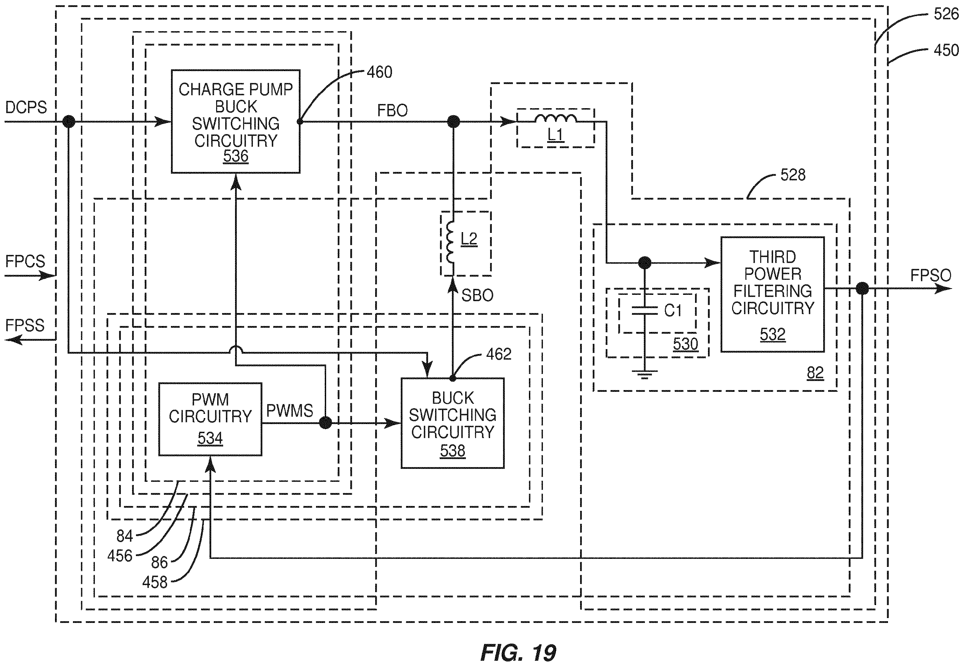

Figure 19 shows details of the first switching power supply 450 illustrated in Figure 16 according to a further embodiment of the first switching power supply 450. The first switching power supply 450 illustrated in Figure 19 is similar to the first switching power supply 450 illustrated in Figure 18, except in the first switching power supply 450 illustrated in Figure 19, the second inductive element L2 is coupled between the first output inductance node 460 and the second output inductance node 462. As such, the buck power supply 528 includes the second inductive element L2 and the charge pump buck power supply 526 and the buck power supply 528 share the first inductive element L1.

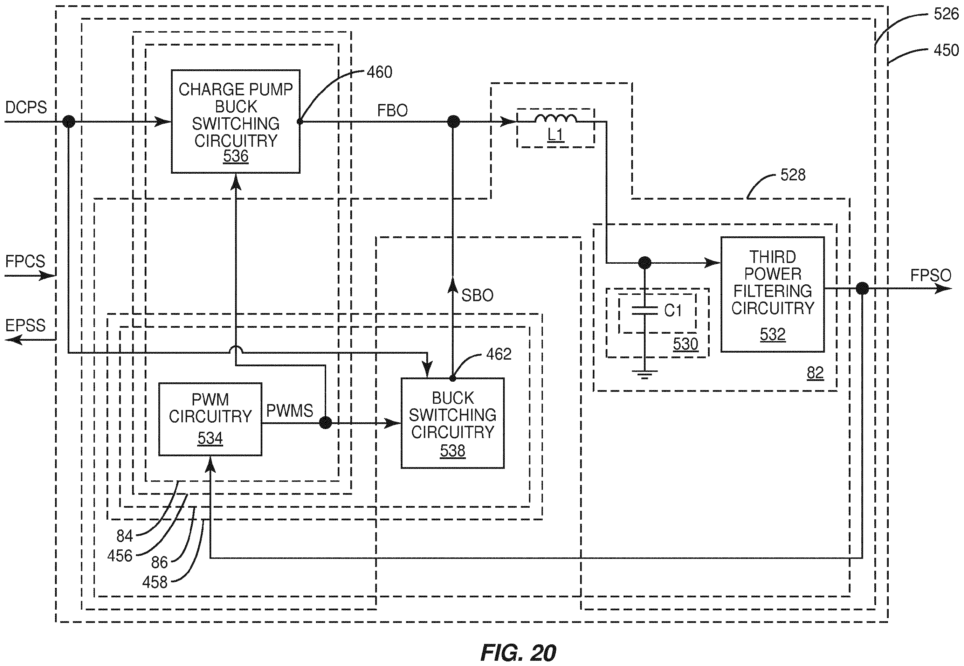

Figure 20 shows details of the first switching power supply 450 illustrated in Figure 17 according to an alternate embodiment of the first switching power supply 450. The first switching power supply 450 includes the charge pump buck power supply 526 and the buck power supply 528. The charge pump buck power supply 526 includes the first switching converter 456, the first inductive element L1, and the first power filtering circuitry 82. The buck power supply 528 includes the second switching converter 458, the first inductive element L1 and the first power filtering circuitry 82. The second switching converter 458 is coupled across the first switching converter 456. The first switching converter 456 is the charge pump buck converter 84, which includes the PWM circuitry 534 and the charge pump buck switching circuitry 536. The second switching converter 458 is the buck converter 86, which includes the PWM circuitry 534 and the buck switching circuitry 538. As such, the charge pump buck converter 84 and the buck converter 86 share the PWM circuitry 534. Further, the charge pump buck power supply 526 and the buck power supply 528 share the PWM circuitry 534, the first inductive element L1, and the first power filtering circuitry 82.

The first power filtering circuitry 82 includes the energy storage element 530 and the third power filtering circuitry 532. In one embodiment of the energy storage element 530, the energy storage element 530 is the first capacitive element C1. The charge pump buck switching circuitry 536 includes the first output inductance node 460 and the buck switching circuitry 538 includes the second output inductance node 462. The first output inductance node 460 is coupled to the second output inductance node 462. As such, the charge pump buck converter 84 has the first output inductance node 460 and the buck converter 86 has the second output inductance node 462. In this regard, the charge pump buck power supply 526 includes the charge pump buck converter 84, the first inductive element L1, and the energy storage element 530. The buck power supply 528 includes the buck converter 86, the first inductive element L1, and the energy storage element 530. As such, the charge pump buck power supply 526 and the buck power supply 528 share the first inductive element L1 and the energy storage element 530.

The first inductive element L1 is coupled between the first output inductance node 460 and the energy storage element 530. Further, the first inductive element L1 is coupled between the second output inductance node 462 and the energy storage element 530. The charge pump buck converter 84 and the first inductive element L1 are coupled in series between the DC power supply 80 (Figure 16) and the energy storage element 530. The buck converter 86 and the first inductive element L1 are coupled in series between the DC power supply 80 (Figure 16) and the energy storage element 530. The buck converter 86 is coupled across the charge pump buck converter 84.

As previously mentioned, in one embodiment of the first switching power supply 450, during the first converter operating mode, the charge pump buck power supply 526 receives and converts the DC power supply signal DCPS from the DC power supply 80 (Figure 16) to provide the first switching power supply output signal FPSO to a load, such as the RF PA circuitry 30 (Figure 5), based on a setpoint. During the first converter operating mode, the buck power supply 528 is disabled. During the second converter operating mode, the buck power supply 528 receives and converts the DC power supply signal DCPS from the DC power supply 80 (Figure 16) to provide the first switching power supply output signal FPSO to the load, such as the RF PA circuitry 30 (Figure 5), based on the setpoint. During the second converter operating mode, the charge pump buck power supply 526 is disabled. The setpoint is based on a desired voltage of the first switching power supply output signal FPSO.

During the first converter operating mode, the first inductive element L1 and the first capacitive element C1 form a lowpass filter, such that the charge pump buck switching circuitry 536 provides the first buck output signal FBO to the lowpass filter, which receives and filters the first buck output signal FBO to provide a filtered first buck output signal to the third power filtering circuitry 532. The third power filtering circuitry 532 receives and filters the filtered first buck output signal to provide the first switching power supply output signal FPSO. During the second converter operating mode, the first inductive element L1 and the first capacitive element C1 form the lowpass filter, such that the buck switching circuitry 538 provides the second buck output signal SBO to the lowpass filter, which receives and filters the second buck output signal SBO to provide a filtered second buck output signal to the third power filtering circuitry 532. The third power filtering circuitry 532 receives and filters the filtered second buck output signal to provide the first switching power supply output signal FPSO.

In one embodiment of the first switching power supply 450, selection of either the first converter operating mode or the second converter operating mode is based on a voltage of the DC power supply signal DCPS and the setpoint. As such, the first converter operating mode is selected when the desired voltage of the first switching power supply output signal FPSO is greater than the voltage of the DC power supply signal DCPS. In an alternate embodiment of the first switching power supply 450, selection of either the first converter operating mode or the second converter operating mode is based on the voltage of the DC power supply signal DCPS, the setpoint, and a load current of the load. As such, the second converter operating mode may be selected when the desired voltage of the first switching power supply output signal FPSO is less than the voltage of the DC power supply signal DCPS and the load current is less than a load current threshold. Selection of either the first converter operating mode or the second converter operating mode may be further based on maximizing efficiency.

In one embodiment of the first switching power supply 450, the control circuitry 42 (Figure 5) provides the setpoint to the DC-DC control circuitry 90 (Figure 16), which selects either the first converter operating mode or the second converter operating mode. As such, the DC configuration control signal DCC (Figure 5) is based on the setpoint. In an alternate embodiment of the first switching power supply 450, the control circuitry 42 (Figure 5) selects either the first converter operating mode or the second converter operating mode and provides the setpoint and the selection of either the first converter operating mode or the second converter operating mode to the DC-DC control circuitry 90 (Figure 16). As such, the DC configuration control signal DCC (Figure 5) is based on the setpoint and the selection of either the first converter operating mode or the second converter operating mode. Further, the DC-DC control circuitry 90 (Figure 16) provides the first power supply control signal FPCS to the first switching power supply 450. As such, the first power supply control signal FPCS is based on the setpoint and the selection of either the first converter operating mode or the second converter operating mode.

The PWM circuitry 534 receives the setpoint and the first switching power supply output signal FPSO. The PWM circuitry 534 provides the PWM signal PWMS to the charge pump buck switching circuitry 536 and the buck switching circuitry 538 based on a difference between the setpoint and the first switching power supply output signal FPSO. The PWM signal PWMS has a duty-cycle based on the difference between the setpoint and the first switching power supply output signal FPSO. During the first converter operating mode, a duty-cycle of the charge pump buck switching circuitry 536 is based on the duty-cycle of the PWM signal PWMS. During the second converter operating mode, a duty-cycle of the buck switching circuitry 538 is based on the duty-cycle of the PWM signal PWMS. In this regard, during the first converter operating mode, the PWM circuitry 534, the charge pump buck switching circuitry 536, the first inductive element L1, the first capacitive element C1, and the third power filtering circuitry 532 form a control loop to regulate the first switching power supply output signal FPSO based on the setpoint. Similarly, during the second converter operating mode, the PWM circuitry 534, the buck switching circuitry 538, the first inductive element L1, the first capacitive element C1, and the third power filtering circuitry 532 form a control loop to regulate the first switching power supply output signal FPSO based on the setpoint.

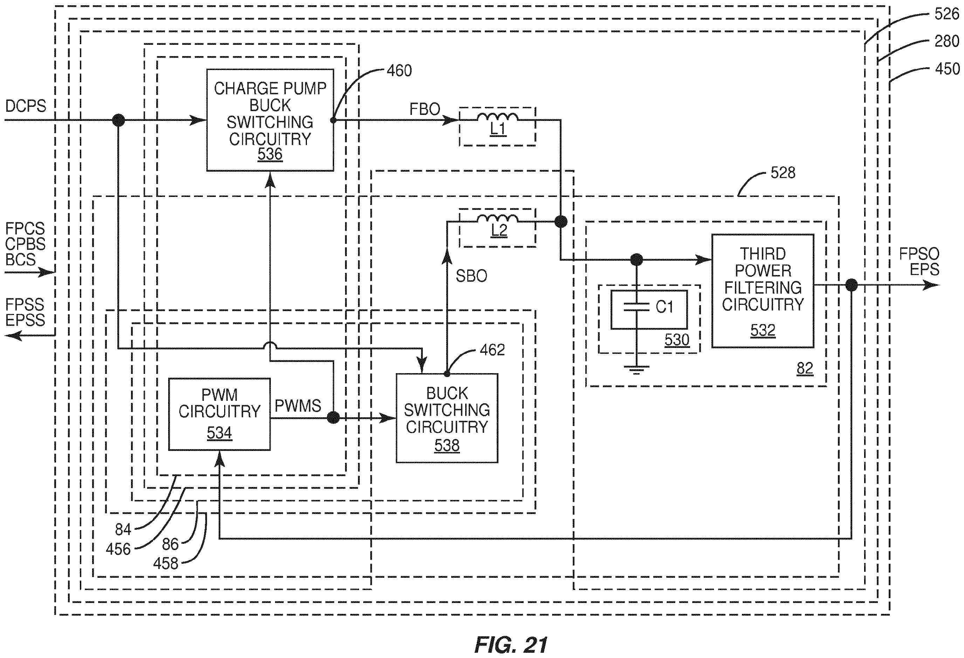

Figure 21 shows details of the first switching power supply 450 illustrated in Figure 16 according to an additional embodiment of the first switching power supply 450. The first switching power supply 450 illustrated in Figure 21 is similar to the first switching power supply 450 illustrated in Figure 18, except the first switching power supply 450 illustrated in Figure 21 is the PA envelope power supply 280. The first switching power supply output signal FPSO is the envelope power supply signal EPS. The first power supply control signal FPCS provides the charge pump buck control signal CPBS and the buck control signal BCS. The first power supply status signal FPSS is the envelope power supply status signal EPSS.

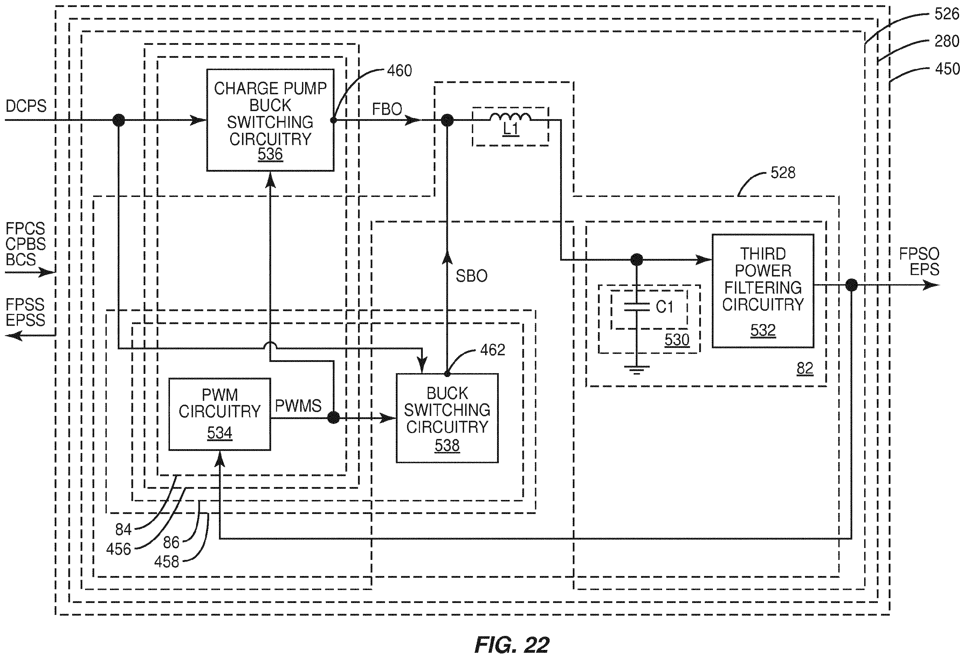

Figure 22 shows details of the first switching power supply 450 illustrated in Figure 17 according to another embodiment of the first switching power supply 450. The first switching power supply 450 illustrated in Figure 22 is similar to the first switching power supply 450 illustrated in Figure 20, except the first switching power supply 450 illustrated in Figure 22 is the PA envelope power supply 280. The first switching power supply output signal FPSO is the envelope power supply signal EPS. The first power supply control signal FPCS provides the charge pump buck control signal CPBS and the buck control signal BCS. The first power supply status signal FPSS is the envelope power supply status signal EPSS.

Figure 23 shows details of the charge pump buck switching circuitry 536 and the buck switching circuitry 538 illustrated in Figure 18 according to one embodiment of the charge pump buck switching circuitry 536 and the buck switching circuitry 538. The charge pump buck switching circuitry 536 includes charge pump buck switching control circuitry 540 and a charge pump buck switch circuit 542. During the first converter operating mode, the charge pump buck switching control circuitry 540 receives the PWM signal PWMS and provides a first shunt pump buck control signal PBN1, a second shunt pump buck control signal PBN2, an alpha charging control signal ACCS, a beta charging control signal BCCS, an alpha discharging control signal ADCS, and a beta discharging control signal BDCS to the charge pump buck switch circuit 542 based on the PWM signal PWMS. The charge pump buck switch circuit 542 has the first output inductance node 460 and receives the DC power supply signal DCPS. During the first converter operating mode, the charge pump buck switch circuit 542 provides the first buck output signal FBO via the first output inductance node 460 based on the DC power supply signal DCPS, the first shunt pump buck control signal PBN1, the second shunt pump buck control signal PBN2, the alpha charging control signal ACCS, the beta charging control signal BCCS, the alpha discharging control signal ADCS, and the beta discharging control signal BDCS.

The buck switching circuitry 538 includes buck switching control circuitry 544 and a buck switch circuit 546. The buck switch circuit 546 includes a first portion 548 of a DC-DC converter semiconductor die 550. The first portion 548 of the DC-DC converter semiconductor die 550 includes a beta inductive element connection node 552, a first shunt buck switching element 554, a second shunt buck switching element 556, a first series buck switching element 558, and a second series buck switching element 560. The buck switch circuit 546 has the second output inductance node 462. The first shunt buck switching element 554, the second shunt buck switching element 556, the first series buck switching element 558, and the second series buck switching element 560 are coupled in series between the DC power supply 80 (Figure 16) and a ground. When the second series buck switching element 560 is ON, the second series buck switching element 560 has a series buck current ISK. A first buck sample signal SSK1 and a second buck sample signal SSK2 are used for measuring a voltage across the second series buck switching element 560.

In one embodiment of the buck switch circuit 546, the first shunt buck switching element 554 is an NMOS transistor element, the second shunt buck switching element 556 is an NMOS transistor element, the first series buck switching element 558 is a PMOS transistor element, and the second series buck switching element 560 is a PMOS transistor element. A source of the second series buck switching element 560 is coupled to the DC power supply 80 (Figure 16). A drain of the second series buck switching element 560 is coupled to a source of the first series buck switching element 558. A drain of the first series buck switching element 558 is coupled to a drain of the second shunt buck switching element 556, to the beta inductive element connection node 552, and to the second output inductance node 462. A source of the second shunt buck switching element 556 is coupled to a drain of the first shunt buck switching element 554. A source of the first shunt buck switching element 554 is coupled to the ground. A gate of the second series buck switching element 560 is coupled to the ground.

During the second converter operating mode, the buck switching control circuitry 544 receives the PWM signal PWMS and provides a first shunt buck control signal BN1, a second shunt buck control signal BN2, and a first series buck control signal BS1 based on the PWM signal PWMS. A gate of the first shunt buck switching element 554 receives the first shunt buck control signal BN1. A gate of the second shunt buck switching element 556 receives the second shunt buck control signal BN2. A gate of the first series buck switching element 558 receives the first series buck control signal BS1. As such, the first shunt buck switching element 554, the second shunt buck switching element 556, the first series buck switching element 558, and the second series buck switching element 560 provide the second buck output signal SBO via the beta inductive element connection node 552 and the second output inductance node 462 based on the first shunt buck control signal BN1, the second shunt buck control signal BN2, and the first series buck control signal BS1.

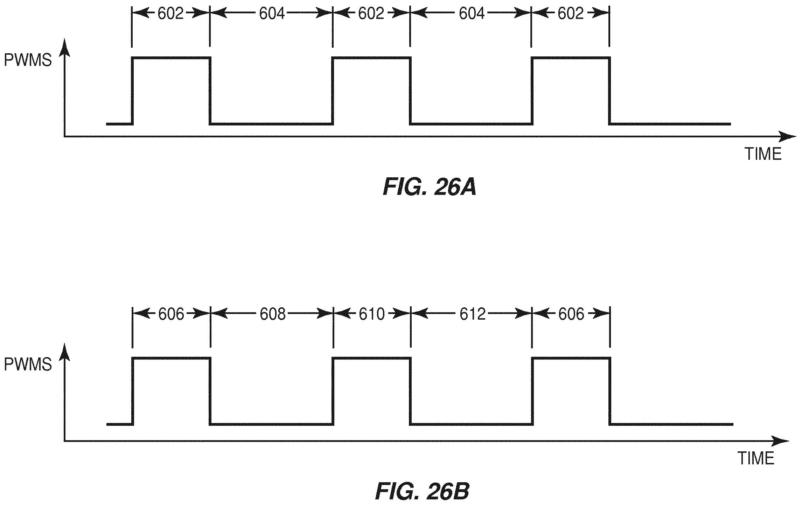

During the second converter operating mode, the PWM signal PWMS has a series phase 602 (Figure 26A) and a shunt phase 604 (Figure 26A). During the series phase 602 (Figure 26A) of the second converter operating mode, the first series buck switching element 558 and the second series buck switching element 560 are both ON, and the first shunt buck switching element 554 and the second shunt buck switching element 556 are both OFF. As such, the DC power supply signal DCPS is forwarded via the first series buck switching element 558 and the second series buck switching element 560 to provide the second buck output signal SBO. During the shunt phase 604 (Figure 26A) of the second converter operating mode, the first series buck switching element 558 is OFF, and the first shunt buck switching element 554 and the second shunt buck switching element 556 are both ON. As such, the beta inductive element connection node 552 and the second output inductance node 462 are coupled to the ground via the first shunt buck switching element 554 and the second shunt buck switching element 556 to provide the second buck output signal SBO.

For the buck power supply 528 (Figure 18) to be voltage compatible with the charge pump buck power supply 526 (Figure 18), the buck power supply 528 (Figure 18) must not be damaged or function improperly in the presence of a voltage at the second output inductance node 462 that is equivalent to a voltage at the first output inductance node 460 during normal operation of the charge pump buck power supply 526 (Figure 18). In an exemplary embodiment of the DC-DC converter 32 (Figure 16), the voltage at the first output inductance node 460 may be as high as about 11 volts and a breakdown voltage of each of the first shunt buck switching element 554, the second shunt buck switching element 556, the first series buck switching element 558, and the second series buck switching element 560 is equal to about 7 volts. Therefore, the first shunt buck switching element 554 and the second shunt buck switching element 556 are cascaded in series to handle the high voltage at the first output inductance node 460. Further, the first series buck switching element 558 and the second series buck switching element 560 are cascaded in series to handle the high voltage at the first output inductance node 460.

In general, the buck converter 86 (Figure 18) has a group of shunt buck switching elements coupled in series between the second output inductance node 462 and the ground. The group of shunt buck switching elements includes the first shunt buck switching element 554 and the second shunt buck switching element 556. The buck converter 86 (Figure 18) has a group of series buck switching elements coupled in series between the DC power supply 80 (Figure 16) and the second output inductance node 462. The group of series buck switching elements includes the first series buck switching element 558 and the second series buck switching element 560. In one embodiment of the buck converter 86 (Figure 18), the first series buck switching element 558 and the second series buck switching element 560 are configured in a cascode arrangement. In general, the group of series buck switching elements may be configured in a cascode arrangement.

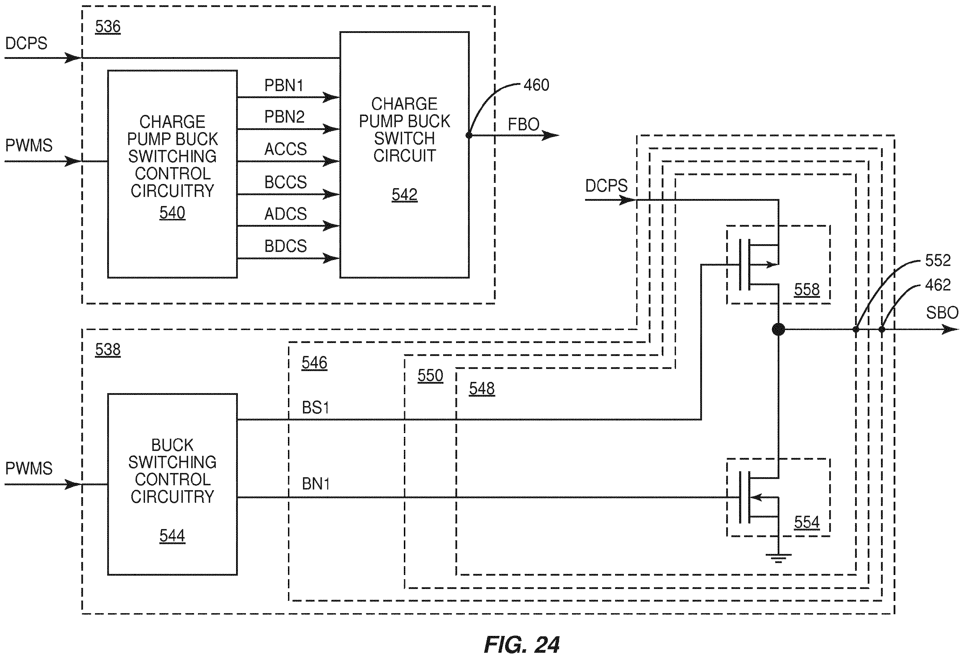

Figure 24 shows details of the charge pump buck switching circuitry 536 and the buck switching circuitry 538 illustrated in Figure 18 according to an alternate embodiment of the buck switching circuitry 538. The buck switching circuitry 538 illustrated in Figure 24 is similar to the buck switching circuitry 538 illustrated in Figure 23, except in the buck switching circuitry 538 illustrated in Figure 24, the second shunt buck switching element 556 and the second series buck switching element 560 are omitted. As such, the first series buck switching element 558 is coupled between the DC power supply 80 (Figure 16) and the second output inductance node 462. In one embodiment of the buck switching circuitry 538, only the first series buck switching element 558 is coupled between the DC power supply 80 (Figure 16) and the second output inductance node 462. Further, the first shunt buck switching element 554 is coupled between the second output inductance node 462 and the ground. In one embodiment of the buck switching circuitry 538, only the first shunt buck switching element 554 is coupled between the second output inductance node 462 and the ground.

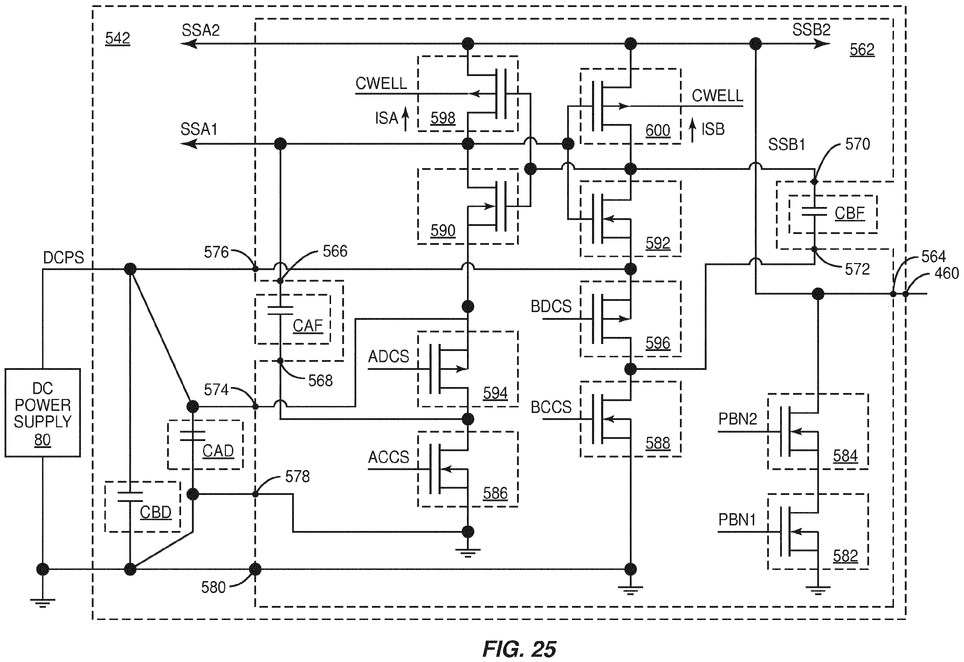

Figure 25 shows details of the charge pump buck switch circuit 542 illustrated in Figure 23 according to one embodiment of the charge pump buck switch circuit 542. The charge pump buck switch circuit 542 includes a second portion 562 of the DC-DC converter semiconductor die 550 (Figure 23), an alpha flying capacitive element CAF, a beta flying capacitive element CBF, an alpha decoupling capacitive element CAD, and a beta decoupling capacitive element CBD.

The second portion 562 of the DC-DC converter semiconductor die 550 (Figure 23) has an alpha inductive element connection node 564, a first alpha flying capacitor connection node 566, a second alpha flying capacitor connection node 568, a first beta flying capacitor connection node 570, a second beta flying capacitor connection node 572, an alpha decoupling connection node 574, a beta decoupling connection node 576, an alpha ground connection node 578, and a beta ground connection node 580. Additionally, the second portion 562 of the DC-DC converter semiconductor die 550 (Figure 23) includes a first shunt pump buck switching element 582, a second shunt pump buck switching element 584, a first alpha charging switching element 586, a first beta charging switching element 588, a second alpha charging switching element 590, a second beta charging switching element 592, a first series alpha switching element 594, a first series beta switching element 596, a second series alpha switching element 598, and a second series beta switching element 600.

When the second series alpha switching element 598 is ON, the second series alpha switching element 598 has a series alpha current ISA. When the second series beta switching element 600 is ON, the second series beta switching element 600 has a series beta current ISB. A first alpha sample signal SSA1 and a second alpha sample signal SSA2 are used for measuring a voltage across the second series alpha switching element 598. A first beta sample signal SSB1 and a second beta sample signal SSB2 are used for measuring a voltage across the second series beta switching element 600.

In one embodiment of the charge pump buck switch circuit 542, the first shunt pump buck switching element 582 is an NMOS transistor element, the second shunt pump buck switching element 584 is an NMOS transistor element, the first alpha charging switching element 586 is an NMOS transistor element, the first beta charging switching element 588 is an NMOS transistor element, the second alpha charging switching element 590 is an NMOS transistor element, and the second beta charging switching element 592 is an NMOS transistor element. Further, the first series alpha switching element 594 is a PMOS transistor element, the first series beta switching element 596 is a PMOS transistor element, the second series alpha switching element 598 is a PMOS transistor element, and the second series beta switching element 600 is a PMOS transistor element.

A source of the first shunt pump buck switching element 582 is coupled to a ground. A drain of the first shunt pump buck switching element 582 is coupled to a source of the second shunt pump buck switching element 584. A drain of the second shunt pump buck switching element 584 is coupled to the alpha inductive element connection node 564. A source of the first alpha charging switching element 586 is coupled to the alpha ground connection node 578 and to the ground. A drain of the first alpha charging switching element 586 is coupled to a first terminal of the first series alpha switching element 594 and to the second alpha flying capacitor connection node 568. A second terminal of the first series alpha switching element 594 is coupled to a first terminal of the second alpha charging switching element 590 and to the alpha decoupling connection node 574. A second terminal of the second alpha charging switching element 590 is coupled to a first terminal of the second series alpha switching element 598, to a gate of the second beta charging switching element 592, to a gate of the second series beta switching element 600, and to the first alpha flying capacitor connection node 566. A second terminal of the second series alpha switching element 598 is coupled to a second terminal of the second series beta switching element 600, and to the alpha inductive element connection node 564.

A source of the first beta charging switching element 588 is coupled to the beta ground connection node 580 and to the ground. A drain of the first beta charging switching element 588 is coupled to a first terminal of the first series beta switching element 596 and to the second beta flying capacitor connection node 572. A second terminal of the first series beta switching element 596 is coupled to a first terminal of the second beta charging switching element 592 and to the beta decoupling connection node 576. A second terminal of the second beta charging switching element 592 is coupled to a first terminal of the second series beta switching element 600, to a gate of the second alpha charging switching element 590, to a gate of the second series alpha switching element 598, and to the first beta flying capacitor connection node 570. A body of the second series alpha switching element 598 is coupled to a CMOS well CWELL. A body of the second series beta switching element 600 is coupled to the CMOS well CWELL.

A gate of the first shunt pump buck switching element 582 receives the first shunt pump buck control signal PBN1. A gate of the second shunt pump buck switching element 584 receives the second shunt pump buck control signal PBN2. A gate of the first alpha charging switching element 586 receives the alpha charging control signal ACCS. A gate of the first beta charging switching element 588 receives the beta charging control signal BCCS. A gate of the first series alpha switching element 594 receives the alpha discharging control signal ADCS. A gate of the first series beta switching element 596 receives the beta discharging control signal BDCS.

A first end of the alpha flying capacitive element CAF is coupled to the second alpha flying capacitor connection node 568. A second end of the alpha flying capacitive element CAF is coupled to the first alpha flying capacitor connection node 566. A first end of the beta flying capacitive element CBF is coupled to the second beta flying capacitor connection node 572. A second end of the beta flying capacitive element CBF is coupled to the first beta flying capacitor connection node 570. A first end of the alpha decoupling capacitive element CAD is coupled to the alpha decoupling connection node 574 and to an output from the DC power supply 80. A first end of the beta decoupling capacitive element CBD is coupled to the beta decoupling connection node 576 and to the output from the DC power supply 80. A second end of the alpha decoupling capacitive element CAD is coupled to the alpha ground connection node 578 and to a ground of the DC power supply 80. A second end of the beta decoupling capacitive element CBD is coupled to the beta ground connection node 580 and to the ground of the DC power supply 80.

The alpha decoupling capacitive element CAD may be tightly coupled to the alpha decoupling connection node 574 and to the alpha ground connection node 578 to maximize decoupling and to minimize the length of transient current paths. The beta decoupling capacitive element CBD may be tightly coupled to the beta decoupling connection node 576 and the beta ground connection node 580 to maximize decoupling and to minimize the length of transient current paths. The alpha flying capacitive element CAF may be tightly coupled to the first alpha flying capacitor connection node 566 and to the second alpha flying capacitor connection node 568 to minimize the length of transient current paths. The beta flying capacitive element CBF may be tightly coupled to the first beta flying capacitor connection node 570 and to the second beta flying capacitor connection node 572 to minimize the length of transient current paths.

During the first converter operating mode, the PWM signal PWMS has an alpha series phase 606 (Figure 26B), an alpha shunt phase 608 (Figure 26B), a beta series phase 610 (Figure 26B), and a beta shunt phase 612 (Figure 26B). During the alpha series phase 606 (Figure 26B) and the alpha shunt phase 608 (Figure 26B), the alpha flying capacitive element CAF is coupled to the DC power supply 80 to be recharged. During the beta series phase 610 (Figure 26B), the alpha flying capacitive element CAF is coupled to the first output inductance node 460 to provide current to the first inductive element L1 (Figure 18). During the beta shunt phase 612 (Figure 26B), the alpha flying capacitive element CAF is disconnected and the first shunt pump buck switching element 582 and the second shunt pump buck switching element 584 are both ON to provide current to the first inductive element L1 (Figure 18). Further, during the beta series phase 610 (Figure 26B) and the beta shunt phase 612 (Figure 26B), the beta flying capacitive element CBF is coupled to the DC power supply 80 to be recharged. During the alpha series phase 606 (Figure 26B), the beta flying capacitive element CBF is coupled to the first output inductance node 460 to provide current to the first inductive element L1 (Figure 18). During the alpha shunt phase 608 (Figure 26B), the beta flying capacitive element CBF is disconnected and the first shunt pump buck switching element 582 and the second shunt pump buck switching element 584 are both ON to provide current to the first inductive element L1 (Figure 18).

In this regard, during the alpha series phase 606 (Figure 26B), the first alpha charging switching element 586, the second alpha charging switching element 590, the first series beta switching element 596, and the second series beta switching element 600 are ON; and the first series alpha switching element 594, the second series alpha switching element 598, the first beta charging switching element 588, the second beta charging switching element 592, the first shunt pump buck switching element 582, and the second shunt pump buck switching element 584 are OFF.

During the alpha shunt phase 608 (Figure 26B), the first alpha charging switching element 586, the second alpha charging switching element 590, the first shunt pump buck switching element 582, and the second shunt pump buck switching element 584 are ON; and the first series alpha switching element 594, the second series alpha switching element 598, the first beta charging switching element 588, the first series beta switching element 596, the second beta charging switching element 592, and the second series beta switching element 600 are OFF.

During the beta series phase 610 (Figure 26B), the first beta charging switching element 588, the second beta charging switching element 592, the first series alpha switching element 594, and the second series alpha switching element 598 are ON, and the first series beta switching element 596, the second series beta switching element 600, the first alpha charging switching element 586, the second alpha charging switching element 590, the first shunt pump buck switching element 582, and the second shunt pump buck switching element 584 are OFF.

During the beta shunt phase 612 (Figure 26B), the first beta charging switching element 588, the second beta charging switching element 592, the first shunt pump buck switching element 582, and the second shunt pump buck switching element 584 are ON, and the first series beta switching element 596, the second series beta switching element 600, the first alpha charging switching element 586, the second alpha charging switching element 590, the first series alpha switching element 594, and the second series alpha switching element 598 are OFF.

In general, the charge pump buck converter 84 (Figure 18) has a group of shunt pump buck switching elements coupled in series between the first output inductance node 460 and the ground. The group of shunt pump buck switching elements includes the first shunt pump buck switching element 582 and the second shunt pump buck switching element 584. The charge pump buck converter 84 (Figure 18) has an alpha group of series pump buck switching elements coupled in series between the DC power supply 80 (Figure 16) and the first output inductance node 460 through the alpha flying capacitive element CAF. The alpha group of series pump buck switching elements includes the first series alpha switching element 594 and the second series alpha switching element 598. Further, the charge pump buck converter 84 (Figure 18) has a beta group of series pump buck switching elements coupled in series between the DC power supply 80 (Figure 16) and the first output inductance node 460 through the beta flying capacitive element CBF. The beta group of series pump buck switching elements includes the first series beta switching element 596 and the second series beta switching element 600.

Figure 26A and Figure 26B are graphs of the PWM signal PWMS of the first switching power supply 450 illustrated in Figure 18 according to one embodiment of the first switching power supply 450 (Figure 18). Figure 26A shows the PWM signal PWMS during the second converter operating mode of the first switching power supply 450 (Figure 18). The PWM signal PWMS alternates between the series phase 602 and the shunt phase 604. Figure 26B shows the PWM signal PWMS during the first converter operating mode of the first switching power supply 450 (Figure 18). The PWM signal PWMS has the alpha series phase 606, which is followed by the alpha shunt phase 608, which is followed by the beta series phase 610, which is followed by the beta shunt phase 612, which is followed by the alpha series phase 606, and so on.

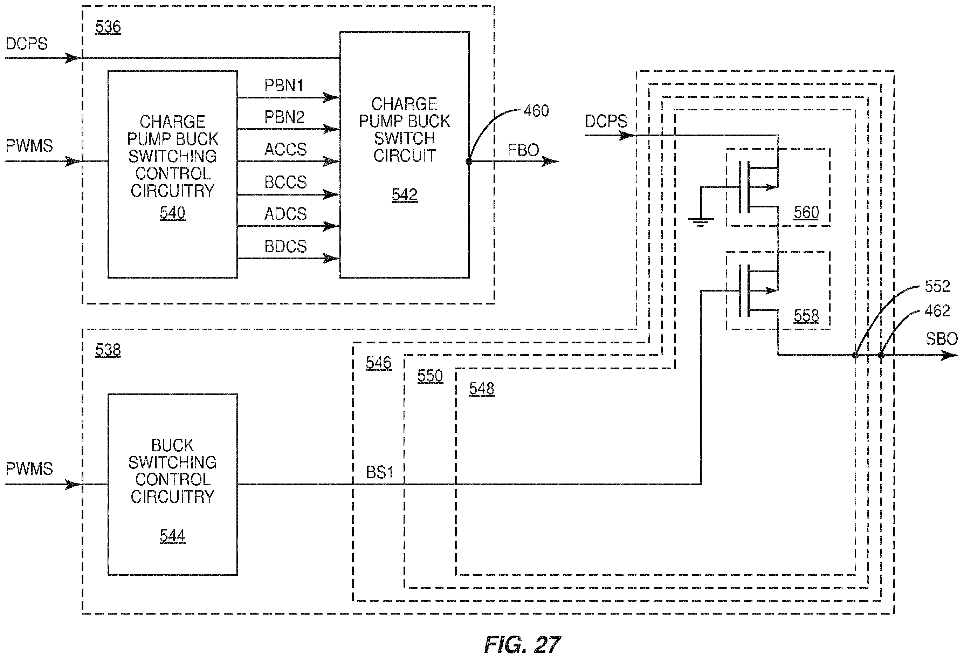

Figure 27 shows details of the charge pump buck switching circuitry 536 and the buck switching circuitry 538 illustrated in Figure 20 according to an additional embodiment of the buck switching circuitry 538. The buck switching circuitry 538 illustrated in Figure 27 is similar to the buck switching circuitry 538 illustrated in Figure 23, except in the buck switching circuitry 538 illustrated in Figure 27, the first shunt buck switching element 554 (Figure 23) and the second shunt buck switching element 556 (Figure 23) are omitted. Instead of using the first shunt buck switching element 554 (Figure 23) and the second shunt buck switching element 556 (Figure 23), the buck power supply 528 (Figure 20) shares the first shunt pump buck switching element 582 (Figure 25) and the second shunt pump buck switching element 584 (Figure 25) with the charge pump buck power supply 526 (Figure 20).

As such, the charge pump buck power supply 526 (Figure 20) includes the first output inductance node 460 (Figure 20), the first inductive element L1 (Figure 20), and at least the first shunt pump buck switching element 582 (Figure 25). The buck power supply 528 (Figure 20) includes the second output inductance node 462, the first inductive element L1 (Figure 20), and at least the first shunt pump buck switching element 582 (Figure 25). The second output inductance node 462 is coupled to the first output inductance node 460. The first inductive element L1 (Figure 20) is coupled between the first output inductance node 460 (Figure 20) and the energy storage element 530 (Figure 20). The first shunt pump buck switching element 582 (Figure 25) is coupled between the first output inductance node 460 (Figure 25) and a ground. The charge pump buck power supply 526 (Figure 20) and the buck power supply 528 (Figure 20) share the first inductive element L1 (Figure 20), the energy storage element 530 (Figure 20), and the first shunt pump buck switching element 582 (Figure 25).

In general, the charge pump buck power supply 526 (Figure 8920) includes a group of shunt pump buck switching elements coupled in series between the first output inductance node 460 and the ground. The group of shunt pump buck switching elements includes at least the first shunt pump buck switching element 582 (Figure 25) and may further include the second shunt pump buck switching element 584 (Figure 25). The charge pump buck power supply 526 (Figure 20) and the buck power supply 528 (Figure 20) share the group of shunt pump buck switching elements.

Some of the circuitry previously described may use discrete circuitry, integrated circuitry, programmable circuitry, non-volatile circuitry, volatile circuitry, software executing instructions on computing hardware, firmware executing instructions on computing hardware, the like, or any combination thereof. The computing hardware may include mainframes, micro-processors, micro-controllers, DSPs, the like, or any combination thereof. The term "coupled," as used in this specification means electrically coupled. Other terms, such as "thermally coupled" or "mechanically coupled" may or may not also be electrically coupled. The term "coupled" refers to elements that may be electrically coupled together either with or without other interposing elements. The term "directly coupled" means directly electrically coupled, such that the elements have an electrical conduction path between them, such that the electrical conduction path has only electrically conductive material.

### First Embodiment: Voltage Compatible Charge Pump Buck and Buck Power Supplies

The present disclosure relates to a flexible DC-DC converter, which includes a charge pump buck power supply and a buck power supply. The charge pump buck power supply and the buck power supply are voltage compatible with one another at respective output inductance nodes to provide flexibility. In one embodiment of the DC-DC converter, capacitances at the output inductance nodes are at least partially isolated from one another by using at least an isolating inductive element between the output inductance nodes to increase efficiency. In an alternate embodiment of the DC-DC converter, the output inductance nodes are coupled to one another, such that the charge pump buck power supply and the buck power supply share a first inductive element, thereby eliminating the isolating inductive element, which reduces size and cost but may also reduce efficiency. In both embodiments, the charge pump buck power supply and the buck power supply share an energy storage element. Specifically, the charge pump buck power supply includes a charge pump buck converter having a first output inductance node, a first inductive element, and the energy storage element, such that the first inductive element is coupled between the first output inductance node and the energy storage element. The buck power supply includes a buck converter having a second output inductance node, and the energy storage element. The buck power supply at the second output inductance node is voltage compatible with the charge pump buck power supply at the first output inductance node to provide flexibility.

Second Embodiment: Charge Pump Based PA Envelope Power Supply and Bias Power Supply

The present disclosure relates to a DC-DC converter, which includes a charge pump based RF PA envelope power supply and a charge pump based PA bias power supply. The DC-DC converter is coupled between RF PA circuitry and a DC power supply, such as a battery. As such, the PA envelope power supply provides an envelope power supply signal to the RF PA circuitry and the PA bias power supply provides a bias power supply signal to the RF PA circuitry. Both the PA envelope power supply and the PA bias power supply receive power via a DC power supply signal from the DC power supply. The PA envelope power supply includes a charge pump buck converter and the PA bias power supply includes a charge pump.

None of the embodiments of the present disclosure are intended to limit the scope of any other embodiment of the present disclosure. Any or all of any embodiment of the present disclosure may be combined with any or all of any other embodiment of the present disclosure to create new embodiments of the present disclosure.

Those skilled in the art will recognize improvements and modifications to the preferred embodiments of the present disclosure. All such improvements and modifications are considered within the scope of the claims that follow.

## Claims

1. Circuitry comprising:
• a charge pump buck power supply (526) comprising a charge pump buck converter (456) having a first output inductance node (460), a first inductive element (L1), and an energy storage element (530), such that the first inductive element (L1) is coupled between the first output inductance node (460) and the energy storage element (530); and
**characterized in** including:
• a buck power supply (528) comprising a buck converter (458) having a second output inductance node (462) and the energy storage element (530), such that:
• the buck power supply (528) at the second output inductance node (462) is voltage compatible with the charge pump buck power supply (84) at the first output inductance node (460); and
• the charge pump buck power supply (526) and the buck power supply (528) share the energy storage element (530).

2. The circuitry of claim 1 wherein the first output inductance node (460) is coupled to the second output inductance node (462), such that the charge pump buck power supply (526) and the buck power supply (528) further share the first inductive element (L1).

3. The circuitry of claim 1 wherein the buck power supply (526) further comprises a second inductive element (L2) coupled between the first output inductance node (460) and the second output inductance node (462), such that the charge pump buck power supply (526) and the buck power supply (528) further share the first inductive element (L1).

4. The circuitry of claim 1 wherein the buck power supply (528) further comprises a second inductive element (L2) coupled between the second output inductance node (462) and the energy storage element (530).

5. The circuitry of claim 1 wherein:
• during a first converter operating mode, the charge pump buck power supply (526) is adapted to receive and convert a direct current (DC) power supply signal from a DC power supply (80) to provide a first switching power supply output signal to a load based on a setpoint; and
• during a second converter operating mode, the buck power supply (528) is adapted to receive and convert the DC power supply (80) signal from the DC power supply (80) to provide the first switching power supply output signal to the load based on the setpoint, wherein the setpoint is based on a desired voltage of the first switching power supply output signal.

6. The circuitry of claim 5 wherein selection of one of the first converter operating mode and the second converter operating mode is based on a voltage of the DC power supply signal and the setpoint, such that the first converter operating mode is selected when the desired voltage of the first switching power supply output signal is greater than the voltage of the DC power supply signal.

7. The circuitry of claim 6 wherein the selection of the one of the first converter operating mode and the second converter operating mode is further based on a load current of the load.

8. The circuitry of claim 5 further comprising control circuitry (42) and DC-DC control circuitry (90), such that:
• the control circuitry (42) is adapted to provide the setpoint to the DC-DC control circuitry (90); and
• the DC-DC control circuitry (90) is adapted to select one of the first converter operating mode and the second converter operating mode.

9. The circuitry of claim 5 further comprising a charge pump adapted to receive and convert the DC power supply signal to provide a second switching power supply output signal.

10. The circuitry of claim 9 wherein:
• the first switching power supply output signal is an envelope power supply signal for a first radio frequency (RF) power amplifier (PA); and
• the second switching power supply output signal is a bias power supply signal used for biasing the first RF PA.

11. The circuitry of claim 5 wherein:
• the buck converter comprises a plurality of shunt buck switching elements (554, 556) coupled in series between the second output inductance node (462) and a ground; and
• the charge pump buck converter (456) comprises a plurality of shunt pump buck switching elements (582, 584) coupled in series between the first output inductance node (460) and the ground.

12. The circuitry of claim 11 wherein:
• the buck converter further comprises a plurality of series buck switching elements (558, 560) coupled in series between the DC power supply (80) and the second output inductance node (462);
• the charge pump buck converter (456) further comprises an alpha plurality of series pump buck switching elements (594, 598) coupled in series between the DC power supply (80) and the first output inductance node (460) through an alpha flying capacitive element (CAF); and
• the charge pump buck converter (456) further comprises a beta plurality of series pump buck switching elements (596, 600) coupled in series between the DC power supply (80) and the first output inductance node (460) through a beta flying capacitive element (CBF).

13. The circuitry of claim 12 wherein the plurality of series buck switching elements (558, 560) is configured in a cascode arrangement.

14. The circuitry of claim 1 wherein the energy storage element (530) is a capacitive element.

15. The circuitry of claim 1 wherein:
• the buck power supply (528) further comprises the first inductive element (L1);
• the charge pump buck converter (456) and the first inductive element (L1) are coupled in series between a direct current (DC) power supply (80) and the energy storage element (530);
• the buck converter is coupled across the charge pump buck converter (456); and
• the charge pump buck power supply (526) and the buck power supply (528) further share the first inductive element (L1).

16. The circuitry of claim 1 wherein:
• the charge pump buck power supply (526) further comprises at least a first shunt pump buck switching element (582);
• the first shunt pump buck switching element (582) is coupled between the first output inductance node (460) and a ground;
• the buck power supply (528) further comprises the first shunt pump buck switching element (582); and
• the charge pump buck power supply (526) and the buck power supply (528) further share the first inductive element (L1) and the first shunt pump buck switching element (582).

17. The circuitry of claim 1 wherein:
• the buck power supply (528) further comprises a second inductive element (L1);
• the charge pump buck converter (456) and the first inductive element (L1) are coupled in series between a direct current (DC) power supply and the energy storage element (530); and
• the buck converter and the second inductive element (L2) are coupled in series between the DC power supply (80) and the energy storage element (530).

## Patentansprüche

1. Schaltsystem, umfassend:
• eine Ladungspumpen-Abwärtsstromversorgung (526), umfassend eine Ladungspumpe mit Abwärtswandler (456), die einen ersten Ausgangs-Induktionsknoten (460), ein erstes induktives Element (L1) und ein Energiespeicherelement (530) umfasst, so dass das erste induktive Element (L1) zwischen dem ersten Ausgangs-Induktionsknoten (460) und dem Energiespeicherelement (530) geschaltet ist; und
**dadurch gekennzeichnet, dass** es Folgendes umfasst:
• eine Abwärtsstromversorgung (528), die einen Abwärtswandler (458) umfasst, der einen zweiten Ausgangs-Induktionsknoten (462) und das Energiespeicherelement (530) aufweist, so dass:
• die Abwärtsstromversorgung (528) am zweiten Ausgangs-Induktionsknoten (462) spannungskompatibel mit der Ladungspumpen-Abwärtsstromversorgung (84) am ersten Ausgangs-Induktionsknoten (460) ist;
und
• die Ladungspumpen-Abwärtsstromversorgung (526) und die Abwärtsstromversorgung (528) gemeinsam das Energiespeicherelement (530) nutzen.

2. Schaltsystem nach Anspruch 1, wobei der erste Ausgangs-Induktionsknoten (460) mit dem zweiten Ausgangs-Induktionsknoten (462) verbunden ist, so dass die Ladungspumpen-Abwärtsstromversorgung (526) und die Abwärtsstromversorgung (528) ferner das erste induktive Element (L1) gemeinsam nutzen.

3. Schaltsystem nach Anspruch 1, wobei die Abwärtsstromversorgung (526) ferner ein zweites induktives Element (L2) umfasst, das zwischen dem ersten Ausgangs-Induktionsknoten (460) und dem zweiten Ausgangs-Induktionsknoten (462) geschaltet ist, so dass die Ladungspumpen-Abwärtsstromversorgung (526) und die Abwärtsstromversorgung (528) ferner das erste induktive Element (L1) gemeinsam nutzen.

4. Schaltsystem nach Anspruch 1, wobei die Abwärtsstromversorgung (528) ferner ein zweites induktives Element (L2) umfasst, das zwischen dem zweiten Ausgangs-Induktionsknoten (462) und dem Energiespeicherelement (530) geschaltet ist.

5. Schaltsystem nach Anspruch 1, wobei:
• während eines ersten Wandlerbetriebsmodus die Ladungspumpen-Abwärtsstromversorgung (526) geeignet ist, um ein Gleichstrom-(DC)-versorgungssignal von einer DC-Stromversorgung (80) zu empfangen und umzuwandeln, um ein erstes Schaltstromversorgungsausgangssignal einer Last basierend auf einem Sollwert bereitzustellen; und
• während eines zweiten Wandlerbetriebsmodus die Abwärtsstromversorgung (528) geeignet ist, um das Signal der DC-Stromversorgung (80) von der DC-Stromversorgung (80) zu empfangen und umzuwandeln, um das erste Schaltstromversorgungsausgangssignal der Last basierend auf dem Sollwert bereitzustellen, wobei der Sollwert auf einer erwünschten Spannung des ersten Schaltstromversorgungsausgangssignals basiert.

6. Schaltsystem nach Anspruch 5, wobei die Auswahl eines aus dem ersten Wandlerbetriebsmodus und dem zweiten Wandlerbetriebsmodus auf einer Spannung des DC-Stromversorgungssignals und dem Sollwert basiert, so dass der erste Wandlerbetriebsmodus ausgewählt wird, wenn die erwünschte Spannung des ersten Schaltstromversorgungsausgangssignals größer als die Spannung des DC-Stromversorgungssignals ist.

7. Schaltsystem nach Anspruch 6, wobei die Auswahl des einen aus dem ersten Wandlerbetriebsmodus und dem zweiten Wandlerbetriebsmodus ferner auf einem Laststrom der Last basiert.

8. Schaltsystem nach Anspruch 5, ferner umfassend eine Steuerschaltung (42) und eine DC-DC-Steuerschaltung (90), so dass:
• die Steuerschaltung (42) geeignet ist, um den Sollwert der die DC-DC-Steuerschaltung (90) bereitzustellen; und
• die DC-DC-Steuerschaltung (90) geeignet ist, einen aus dem ersten Wandlerbetriebsmodus und dem zweiten Wandlerbetriebsmodus auszuwählen.

9. Schaltsystem nach Anspruch 5, ferner umfassend eine Ladungspumpe, die geeignet ist, um das DC-Stromversorgungssignal zu empfangen und umzuwandeln, um ein zweites Schaltstromversorgungsausgangssignal bereitzustellen.

10. Schaltsystem nach Anspruch 9, wobei:
• das erste Schaltstromversorgungsausgangssignal ein Hüllstromversorgungssignal für einen ersten Hochfrequenz-(HF)-Leistungsverstärker (PA) ist; und
• das zweite Schaltstromversorgungsausgangssignal ein Vorspannungsstromversorgungssignal ist, das für das Vorspannen des ersten HF-PA verwendet wird.

11. Schaltsystem nach Anspruch 5, wobei:
• der Abwärtswandler eine Vielzahl von Shunt-Abwärtsschaltelementen (554, 556) umfasst, die in Reihe zwischen dem zweiten Ausgangs-Induktionsknoten (462) und einer Erdung geschaltet sind; und
• die Ladungspumpe mit Abwärtswandler (456) eine Vielzahl von Shunt-Pumpen-Abwärtsschaltelementen (582, 584) umfasst, die in Reihe zwischen dem ersten Ausgangs-Induktionsknoten (460) und der Erdung geschaltet sind.

12. Schaltsystem nach Anspruch 11, wobei:
• der Abwärtswandler ferner eine Vielzahl von Reihen-Abwärtsschaltelementen (558, 560) umfasst, die in Reihe zwischen der DC-Stromversorgung (80) und dem zweiten Ausgangs-Induktionsknoten (462) geschaltet sind;
• die Ladungspumpe mit Abwärtswandler (456) ferner eine Alpha-Vielzahl von Reihen-Pumpen-Abwärtsschaltelementen (594, 598) umfasst, die in Reihe zwischen der DC-Stromversorgung (80) und dem ersten Ausgangs-Induktionsknoten (460) durch ein fliegendes Alpha-Kondensatorelement (CAF) geschaltet sind; und
• die Ladungspumpe mit Abwärtswandler (456) ferner eine Beta-Vielzahl von Reihen-Pumpen-Abwärtsschaltelementen (596, 600) umfasst, die in Reihe zwischen der DC-Stromversorgung (80) und dem ersten Ausgangs-Induktionsknoten (460) durch ein fliegendes Beta-Kondensatorelement (CBF) geschaltet sind.

13. Schaltsystem nach Anspruch 12, wobei die Vielzahl von Reihen-Abwärtsschaltelementen (558, 560) in einer Kaskoden-Anordnung konfiguriert ist.

14. Schaltsystem nach Anspruch 1, wobei das Energiespeicherelement (530) ein Kondensatorelement ist.

15. Schaltsystem nach Anspruch 1, wobei:
• die Abwärtsstromversorgung (528) ferner das erste induktive Element (L1) umfasst;
• die Ladungspumpe mit Abwärtswandler (456) und das erste induktive Element (L1) in Reihe zwischen einer Gleichstrom-(DC)-stromversorgung (80) und dem Energiespeicherelement (530) geschaltet sind;
• der Abwärtswandler über die Ladungspumpe mit Abwärtswandler (456) angeschlossen ist; und
• die Ladungspumpen-Abwärtsstromversorgung (526) und die Abwärtsstromversorgung (528) ferner das erste induktive Element (L1) gemeinsam nutzen.

16. Schaltsystem nach Anspruch 1, wobei:
• die Ladungspumpen-Abwärtsstromversorgung (526) ferner mindestens ein erstes Shunt-Pumpen-Abwärtsschaltelement (582) umfasst;
• das erste Shunt-Pumpen-Abwärtsschaltelement (582) zwischen dem ersten Ausgangs-Induktionsknoten (460) und einer Erdung geschaltet ist;
• die Abwärtsstromversorgung (528) ferner das erste Shunt-Pumpen-Abwärtsschaltelement (582) umfasst; und
• die Ladungspumpen-Abwärtsstromversorgung (526) und die Abwärtsstromversorgung (528) ferner das erste induktive Element (L1) und das erste Shunt-Pumpen-Abwärtsschaltelement (582) gemeinsam nutzen.

17. Schaltsystem nach Anspruch 1, wobei:
• die Abwärtsstromversorgung (528) ferner ein zweites induktives Element (L1) umfasst;
• die Ladungspumpe mit Abwärtswandler (456) und das erste induktive Element (L1) in Reihe zwischen einer Gleichstrom-(DC)-stromversorgung und dem Energiespeicherelement (530) geschaltet sind; und
• der Abwärtswandler und das zweite induktive Element (L2) in Reihe zwischen der DC-Stromversorgung (80) und dem Energiespeicherelement (530) geschaltet sind.

## Revendications

1. Circuit comprenant :
• un bloc d'alimentation abaisseur de tension de pompe de charge (526) comprenant un convertisseur abaisseur de tension de pompe de charge (456) ayant un premier noeud d'inductance de sortie (460), un premier élément inductif (L1) et un élément de stockage d'énergie (530), de sorte que le premier élément inductif (L1) est couplé entre le premier noeud d'inductance de sortie (460) et l'élément de stockage d'énergie (530) ; et **caractérisé en ce qu'**il comprend :
• un bloc d'alimentation abaisseur de tension (528) comprenant un convertisseur abaisseur de tension (458) ayant un second noeud d'inductance de sortie (462) et l'élément de stockage d'énergie (530), de sorte que :
o le bloc d'alimentation abaisseur de tension (528) au niveau du second noeud d'inductance de sortie (462) est compatible en tension avec le bloc d'alimentation abaisseur de tension de pompe de charge (84) au niveau du premier noeud d'inductance de sortie (460) ; et
o le bloc d'alimentation abaisseur de tension de pompe de charge (526) et le bloc d'alimentation abaisseur de tension (528) partagent l'élément de stockage d'énergie (530).

2. Circuit selon la revendication 1, dans lequel le premier noeud d'inductance de sortie (460) est couplé au second noeud d'inductance de sortie (462), de sorte que le bloc d'alimentation abaisseur de tension de pompe de charge (526) et le bloc d'alimentation abaisseur de tension (528) partagent en outre le premier élément inductif (L1).

3. Circuit selon la revendication 1, dans lequel le bloc d'alimentation abaisseur de tension (526) comprend en outre un second élément inductif (L2) couplé entre le premier noeud d'inductance de sortie (460) et le second noeud d'inductance de sortie (462), de sorte que le bloc d'alimentation abaisseur de tension de pompe de charge (526) et le bloc d'alimentation abaisseur de tension (528) partagent en outre le premier élément inductif (L1).

4. Circuit selon la revendication 1, dans lequel le bloc d'alimentation abaisseur de tension (528) comprend en outre un second élément inductif (L2) couplé entre le second noeud d'inductance de sortie (462) et l'élément de stockage d'énergie (530).

5. Circuit selon la revendication 1, dans lequel :
• au cours d'un premier mode de fonctionnement de convertisseur, le bloc d'alimentation abaisseur de tension de pompe de charge (526) est conçu pour recevoir et convertir un signal de bloc d'alimentation à courant continu (CC) à partir d'un bloc d'alimentation CC (80) pour fournir un premier signal de sortie de bloc d'alimentation de commutation à une charge sur la base d'une consigne ; et
• au cours d'un second mode de fonctionnement de convertisseur, le bloc d'alimentation abaisseur de tension (528) est conçu pour recevoir et convertir le signal de bloc d'alimentation CC (80) à partir du bloc d'alimentation CC (80) pour fournir le premier signal de sortie de bloc d'alimentation de commutation à la charge sur la base de la consigne, dans lequel la consigne est basée sur une tension souhaitée du premier signal de sortie de bloc d'alimentation de commutation.

6. Circuit selon la revendication 5, dans lequel la sélection de l'un du premier mode de fonctionnement de convertisseur et du second mode de fonctionnement de convertisseur est basée sur une tension du signal de bloc d'alimentation CC et la consigne, de sorte que le premier mode de fonctionnement de convertisseur est sélectionné lorsque la tension souhaitée du premier signal de sortie de bloc d'alimentation de commutation est supérieure à la tension du signal de bloc d'alimentation CC.

7. Circuit selon la revendication 6, dans lequel la sélection de l'un du premier mode de fonctionnement de convertisseur et du second mode de fonctionnement de convertisseur est en outre basée sur un courant de charge de la charge.

8. Circuit selon la revendication 5, comprenant en outre un circuit de commande (42) et un circuit de commande CC-CC (90), de sorte que :
• le circuit de commande (42) est conçu pour fournir la consigne au circuit de commande CC-CC (90) ; et
• le circuit de commande CC-CC (90) est conçu pour sélectionner l'un du premier mode de fonctionnement de convertisseur et du second mode de fonctionnement de convertisseur.

9. Circuit selon la revendication 5 comprenant en outre une pompe de charge conçue pour recevoir et convertir le signal de bloc d'alimentation CC afin de fournir un second signal de sortie de bloc d'alimentation de commutation.

10. Circuit selon la revendication 9, dans lequel :
• le premier signal de sortie de bloc d'alimentation de commutation est un signal de bloc d'alimentation d'enveloppe pour un premier amplificateur de puissance (PA) radiofréquence (RF) ; et
• le second signal de sortie de bloc d'alimentation de commutation est un signal de bloc d'alimentation de polarisation utilisé pour polariser le premier PA RF.

11. Circuit selon la revendication 5, dans lequel :
• le convertisseur abaisseur de tension comprend une pluralité d'éléments de commutation abaisseurs de tension shunt (554, 556) couplés en série entre le second noeud d'inductance de sortie (462) et un sol ; et
• le convertisseur abaisseur de tension de pompe de charge (456) comprend une pluralité d'éléments de commutation abaisseurs de tension de pompe shunt (582, 584) couplés en série entre le premier noeud d'inductance de sortie (460) et le sol.

12. Circuit selon la revendication 11, dans lequel :
• le convertisseur abaisseur de tension comprend en outre une pluralité d'éléments de commutation abaisseurs de tension en série (558, 560) couplés en série entre le bloc d'alimentation CC (80) et le second noeud d'inductance de sortie (462) ;
• le convertisseur abaisseur de tension de pompe de charge (456) comprend en outre une pluralité alpha d'éléments de commutation abaisseurs de tension de pompe en série (594, 598) couplés en série entre le bloc d'alimentation CC (80) et le premier noeud d'inductance de sortie (460) à travers un élément capacitif volant alpha (CAF) ; et
• le convertisseur abaisseur de tension de pompe de charge (456) comprend en outre une pluralité bêta d'éléments de commutation abaisseurs de tension de pompe en série (596, 600) couplés en série entre le bloc d'alimentation CC (80) et le premier noeud d'inductance de sortie (460) à travers un élément capacitif volant bêta (CBF).

13. Circuit selon la revendication 12, dans lequel la pluralité d'éléments de commutation abaisseurs de tension en série (558, 560) est configurée dans un agencement cascode.

14. Circuit selon la revendication 1, dans lequel l'élément de stockage d'énergie (530) est un élément capacitif.

15. Circuit selon la revendication 1, dans lequel :
• le bloc d'alimentation abaisseur de tension (528) comprend en outre le premier élément inductif (L1) ;
• le convertisseur abaisseur de tension de pompe de charge (456) et le premier élément inductif (L1) sont couplés entre un bloc d'alimentation à courant continu (CC) (80) et l'élément de stockage d'énergie (530) ;
• le convertisseur abaisseur de tension est couplé à travers le convertisseur abaisseur de tension de pompe de charge (456) ; et
• le bloc d'alimentation abaisseur de tension de pompe de charge (526) et le bloc d'alimentation abaisseur de tension (528) partagent en outre le premier élément inductif (L1).

16. Circuit selon la revendication 1, dans lequel :
• le bloc d'alimentation abaisseur de tension de pompe de charge (526) comprend en outre au moins un premier élément de commutation abaisseur de tension de pompe shunt (582) ;
• le premier élément de commutation abaisseur de tension de pompe shunt (582) est couplé entre le premier noeud d'inductance de sortie (460) et un sol ;
• le bloc d'alimentation abaisseur de tension (528) comprend en outre le premier élément de commutation abaisseur de tension de pompe shunt (582) ; et
• le bloc d'alimentation abaisseur de tension de pompe de charge (526) et le bloc d'alimentation abaisseur de tension (528) partagent en outre le premier élément inductif (L1) et le premier élément de commutation abaisseur de tension de pompe shunt (582).

17. Circuit selon la revendication 1, dans lequel :
• le bloc d'alimentation abaisseur de tension (528) comprend en outre un second élément inductif (L1) ;
• le convertisseur abaisseur de tension de pompe de charge (456) et le premier élément inductif (L1) sont couplés en série entre un bloc d'alimentation à courant continu (CC) et l'élément de stockage d'énergie (530) ; et
• le convertisseur abaisseur de tension et le second élément inductif (L2) sont couplés en série entre le bloc d'alimentation CC (80) et l'élément de stockage d'énergie (530) .
